Europäisches Patentamt

European Patent Office

Office européen des brevets

(19)

(11) EP 0 840 350 A2

(12) EUROPEAN PATENT APPLICATION

(43) Date of publication:
06.05.1998 Bulletin 1998/19

(51) Int Cl.⁶: H01J 37/32

(21) Application number: 97308826.3

(22) Date of filing: 04.11.1997

(84) Designated Contracting States:
AT BE CH DE DK ES FI FR GB GR IE IT LI LU MC NL PT SE
Designated Extension States:
AL LT LV MK RO SI

(30) Priority: 04.11.1996 US 743059
04.04.1997 US 832743

(71) Applicant: Applied Materials, Inc.
Santa Clara, California 95054 (US)

(72) Inventors:
• Collins, Kenneth
San Jose, CA 95111 (US)
• Roderick, Craig
San Jose, CA 95117 (US)
• Buchberger, Douglas
Tracy, CA 95376 (US)
• Trow, john
San Jose, CA 95111 (US)
• Shel, Viktor
Milpitas, CA 95035 (US)

(74) Representative: Bayliss, Geoffrey Cyril et al
BOULT WADE TENNANT,
27 Furnival Street
London EC4A 1PQ (GB)

(54) **Plasma apparatus and process with filtering of plasma sheath-generated harmonics**

(57) The invention is embodied in an RF plasma reactor for processing a workpiece in a plasma region within a chamber of the reactor, the reactor including an RF power applicator facing the plasma region and having an RF power input terminal, an RF power generator having a fundamental frequency and having an RF power output terminal, an impedance match network connected between the RF generator output terminal and the RF power input terminal of the RF power applicator, the impedance match network having an impedance at the fundamental frequency related generally to a complex conjugate of a load impedance measurable at the RF power input terminal looking toward the RF power applicator, and a harmonic impedance element connected between the impedance match network and the RF power input terminal of the RF power applicator, the harmonic impedance element having an impedance at a harmonic frequency of the fundamental frequency which is higher than the impedance of the impedance match network at the harmonic frequency, whereby to isolate harmonic frequencies generated in a plasma sheath near the electrode from the impedance match network.

FIG. 6

# Description

This application is related to the simultaneously filed European application No. 97 _____ (which claims priority from U.S. application Serial No. 08/743059).

## BACKGROUND OF THE INVENTION

### Technical Field:

This invention applies to plasma discharges generated by radio frequency power sources and to plasma processes and equipment employing radio frequency generated plasma discharges.

### Background Art:

#### (1) Harmonic Generation At The Plasma Sheath:

RF plasma reactors employ a radio frequency (RF) power source coupled to a power applicator. The power applicator can be a coil or antenna for primarily inductively coupling RF power to the plasma, or may be one or more electrodes for primarily capacitively coupling RF power to the plasma, or may be a combination of both.

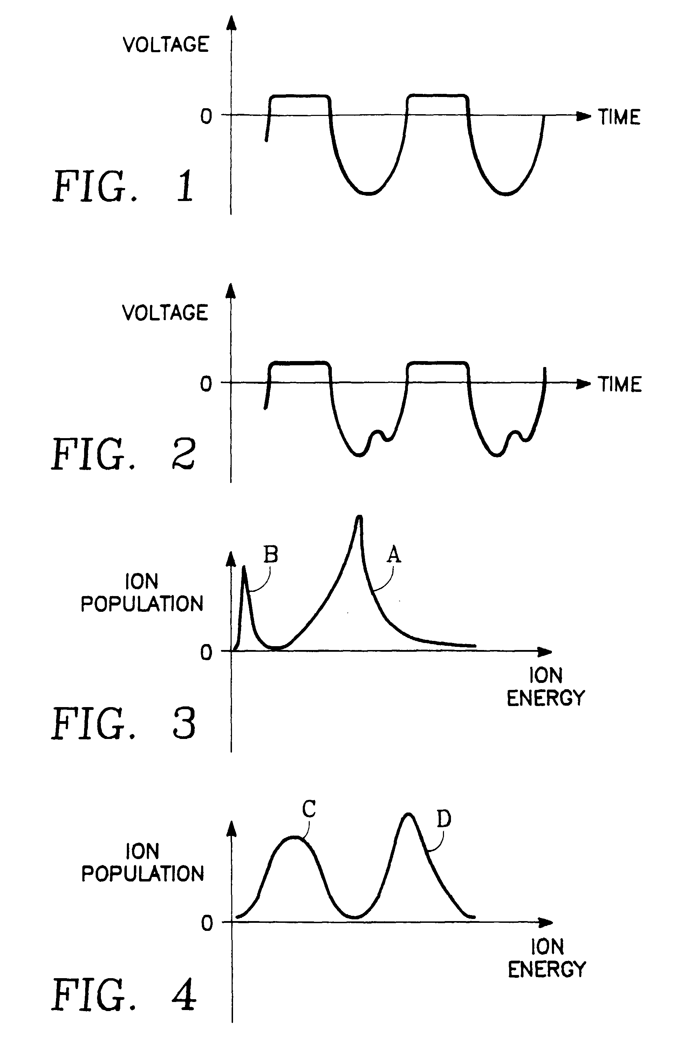

Capacitive coupling of RF power to a plasma requires coupling to or across a plasma sheath that forms at the electrode (or workpiece) boundary with the plasma. The sheath develops due to the vast difference in mobilities between electrons and positive ions in the plasma and because DC current in the electrode circuit is blocked by a DC blocking capacitor or insulator, and its voltage resembles a negative half-wave rectified sinusoid (FIG. 1). This is typical of a high electron density low electron temperature plasma having a low frequency sheath (bias) voltage. Application of RF power to the electrode(s) results in self-"adjustment" of the sheath thickness and voltage to maintain no net DC current. The sheath, generally depleted of electrons, is a nonlinear load for the RF power. As such, coupling RF power to the sheath results in generation of harmonic frequencies from the fundamental RF power frequency. This generation of harmonic frequencies at the sheath can occur even though the RF power source is "clean" (i.e., free of any frequency components other than the fundamental RF frequency), and provides the half-wave rectified sheath voltage sinusoid of FIG. 1. However, distortion of the phase or amplitude of such harmonics will introduce distortions into the sheath voltage waveform.

In a typical high density plasma reactor, the plasma is principally generated by an inductively-coupled plasma power applicator, and RF bias power is capacitively coupled to one or more electrodes (such as the wafer pedestal or electrostatic chuck) constituting a bias power applicator. Typically, inductively-coupled power is selected to define the desired bulk plasma characteristics (plasma electron energy distribution and electron and ion densities), while capacitively coupled RF bias power is selected to define the ion energy on the workpiece being processed. The sheath characteristics depend on the plasma density and electron temperature (i.e., the electron energy distribution), the power and frequency of the capacitively-coupled RF power applied to the electrode and other factors such as the composition and pressure of the gas mixture.

It is a discovery of the present invention that in such a reactor the resultant ion energy distribution at the workpiece is intimately related to the harmonic content of the sheath voltage waveform. The ion energy distribution at the workpiece sheath determines the characteristics of the plasma process being performed on the workpiece. Therefore, it may be said that the harmonic content of the sheath voltage waveform determines the characteristics of the plasma process carried out on the workpiece. For example, in order to etch vertical openings having a high aspect ratio (e.g., opening diameter < 35% opening depth) through a $SiO_2$ film using a fluorocarbon plasma, relatively high ion energies (at least several hundred eV) are required to etch with vertical profile at high rates (greater than 5000 Å/min). Without such high ion energies, etch stopping may occur. Etch stopping is most likely to occur when etching high aspect ratio openings in the film, such as an opening whose width is less than .35 of its height.

We have found that the etch process is generally free of etch stopping or similar effects if the preferred sheath voltage time domain waveform (FIG. 1) generally resembles a negative half-wave rectified sinusoid with a minimal positive D.C. offset. We have found that etch stopping or similar effects occur when the waveform of FIG. 1 is changed to one in which apparently the phase, and possibly the amplitude, of certain harmonics (such as the second or third harmonics) have been perturbed to produce a minor non-half-wave-rectified-sinusoid peak in the time domain waveform (FIG. 2). In investigating these discoveries, we found that the ion energy distribution undergoes a corresponding change. The "normal" sheath voltage waveform of FIG. 1 coincides with "single predominant mode" ion energy distribution illustrated in FIG. 3 in which there is a single predominant peak ("A" in FIG. 3) at an energy coinciding with the peak of the sheath voltage waveform, as well as a very narrow secondary peak ("B" in FIG. 3) near zero energy. The "perturbed" sheath voltage waveform coincides with a "dual mode" ion energy distribution illustrated in FIG. 4 in which there are two dominant peaks ("C" and "D"). The "perturbed" sheath voltage time domain waveform of FIG. 2 and the "dual predominant mode" ion energy distribution appear to always accompany one another and coincide with the etch stopping effects referred to above. We feel that the differences between the normal waveform of FIG. 1 and the "perturbed" waveform of FIG. 2 are due to differences in the nonlinear interaction of the RF signal with the plasma sheath at the workpiece surface, and in particular is due to differences in phase and possibly amplitude of certain harmonics of the sheath voltage.

The "dual mode" ion energy distribution of FIG. 4 associated with the "perturbed" sheath voltage waveform of FIG. 2 would appear to indicate that some of the ion flux has been diverted to a lower energy region (the lower energy peak of FIG. 4), so that not as much ion flux is available at the higher energy region (the higher energy peak of FIG. 4). This may be a possible explanation for the inferior etch performance encountered with the "perturbed" waveform.

We believe we have discovered that one cause of the distortion of the half-wave rectified sinusoid waveform illustrated in FIG. 2 is that the match circuit, while providing a good match or conjugate impedance at the fundamental frequency, provides an insufficient impedance at the second and third harmonics. Thus, the match circuit impedance may be lower than the impedance of the plasma sheath at these harmonic frequencies, so that the harmonic components of the current flow in the plasma sheath build up quickly during each RF cycle before stabilizing self-adjusting conditions in the plasma sheath can arise to counter them. One reason that this may cause inferior plasma process characteristics (such as etch stopping) probably is that more bias power is thus coupled to the bulk plasma than would otherwise be available to accelerate ions across the plasma sheath over the wafer to regulate ion bombardment energy at the wafer surface.

In addition, we have found that the RF power system circuit can affect the harmonic content of the sheath voltage waveform. The matching circuit, the interconnecting power transmission lines, the distributed circuit of the electrode(s) structure, chamber and ground return all can affect the development of harmonics at the electrode(s) sheath, which perturb the sheath voltage time domain waveform and the ion energy distribution, giving rise to the "perturbed" sheath voltage waveform of FIG. 2.

This sensitivity of the harmonic generation at the plasma sheath to differences in the chamber hardware creates a practical problem: there can be great differences between the sheath voltage waveforms of different chambers of the same design, due to small manufacturing differences between chambers of the same model. Thus, for a given set of process conditions, one chamber of a given design may exhibit the sheath waveform of FIG. 1, while the next may exhibit the sheath waveform of FIG. 2. Thus, there is a great need to ameliorate or eliminate such sensitivity.

In view of our discovery set forth above, it would appear that plasma processing could be desirably affected by somehow controlling the generation of harmonics at the plasma sheath. However, the problem is complicated by the fact that the generation of harmonics at the sheath is not only a function of the plasma sheath characteristics, but is also a function of the RF matching circuit, the interconnecting power transmission lines and the distributed circuit of the chamber electrodes, walls, ground returns and the like. A further complication arises with a match circuit employing frequency tuning, because the frequency of the harmonics generated at the sheath varies as the frequency tuning servo varies the fundamental frequency in response to changes the load impedance. For example, the tuning range of the fundamental frequency may extend from 1.5 MHz to 1.9 MHz.

The RF match circuit should provide a conjugate impedance to the plasma load impedance at the fundamental frequency of the applied RF signal on the workpiece. One problem is that the RF match circuit must provide a match at a particular fundamental RF frequency across a range of plasma load impedances. The RF match circuit is designed so that, under ideal load conditions, this range is optimum and covers the entire range of plasma load impedances which are anticipated to arise during processing. However, the interaction between the plasma sheath and the RF signal applied to the workpiece tends to reduce the effective impedance range of the impedance match circuit. This is because, as we have discovered, the impedance match circuit does not necessarily provide a conjugate impedance at the second and third harmonics, but typically constitutes a relatively low impedance at these harmonics, giving rise to the problematic anomalies discussed above. Circuit designers not understanding this and attempting to optimize match circuit performance under these conditions have been forced unwittingly into match circuit design choices which, unbeknownst to them, compromise the impedance range of the match circuit from that which would be otherwise possible. Thus, the impedance matching range of the matching circuit is affected by (or is coupled to) the harmonic frequency generation at the plasma sheath.

It is an object of the present invention to decouple the harmonic frequency generation at the electrode sheath from the matching circuit, the interconnecting power transmission lines, the distributed circuit of the electrode structure, chamber, ground return, and similar elements.

It is a related object to isolate the plasma electrode sheath from the matching circuit at harmonic frequencies, the interconnecting power transmission lines, the distributed circuit of the electrode structure, chamber, ground return, and similar elements.

It is a further object to decouple the matching range of the matching circuit from the harmonic frequency generation at the electrode sheath.

It is a related object to decouple the matching range of the matching circuit using a frequency-tuned system from the harmonic frequency generation at the electrode sheath.

It is another related object to decouple the matching range of a matching circuit employing frequency-tuning and servoing of a parameter (such as delivered power or voltage or current or di/dt, or the like) from the harmonic frequency generation at the electrode sheath.

It is an object to control the harmonic frequency generation at the electrode sheath.

It is a related object to control the ion energy distribution at the electrode sheath.

It is an object to integrate apparatus that isolates the electrode sheath at harmonic frequencies and matches the RF bias power source impedance to the electrode sheath load impedance.

It is a related object to integrate apparatus that isolates the electrode sheath at harmonic frequencies and matches the RF bias power source impedance to the electrode sheath impedance using frequency tuning.

It is another related object to integrate apparatus that isolates the electrode sheath at harmonic frequencies and matching of the RF bias power source impedance to the electrode sheath impedance using frequency tuning and servoing of a parameter such as delivered power or voltage or current or di/dt.

(2) Background of Frequency Tuning and Parameter Servoing:

RF plasma reactors of the type employed in processing semiconductor wafers require a large amount of RF power to maintain a plasma within a vacuum chamber, typically on the order of a thousand watts at RF frequencies on the order of several megaHertz. To maintain a high density plasma, the RF power is best inductively coupled into the chamber via an overlying coil antenna, while plasma ion energy can be controlled by controlling the voltage on the semiconductor wafer being processed. Typically, the RF signal source is an RF generator having an output impedance of 50Ω with substantially no reactance. The input impedance presented by the plasma-loaded coil antenna is typically not 50Ω and has substantial reactance, so that there is a substantial impedance mismatch. For example, the coil antenna typically has a length much less than a quarter wavelength of the RF signal, so that the coil antenna presents an impedance having a real part much less than that of the RF generator (which is typically 50Ω) and having a very high inductive reactance. Such a mismatch causes RF power to be wasted by reflection back to the RF generator rather than being delivered to the plasma, so that it is difficult to control the amount of RF power delivered to the plasma. As a result, process control is compromised. One solution to this problem is to provide a fixed RF match circuit having lumped reactive elements so as to maintain a zero phase angle between RF voltage and current. Moreover, optionally a transformer can be employed to provide a match between the output and input impedance magnitudes.

The problem with such a fixed match circuit is that the input impedance of the plasma-loaded coil antenna changes as process conditions inside the reactor chamber change. Thus, as changes in plasma conditions change the plasma-loaded antenna impedance, the match circuit no longer can perform its function, and RF power delivered to the plasma falls off. Such a reduction in delivered RF power typically distorts the plasma processing of the wafer and in many cases is unacceptable. Therefore, the best solution in the art is to provide an RF impedance matching apparatus that adjusts the impedance match in response to changes in the plasma-loaded impedance of the antenna.

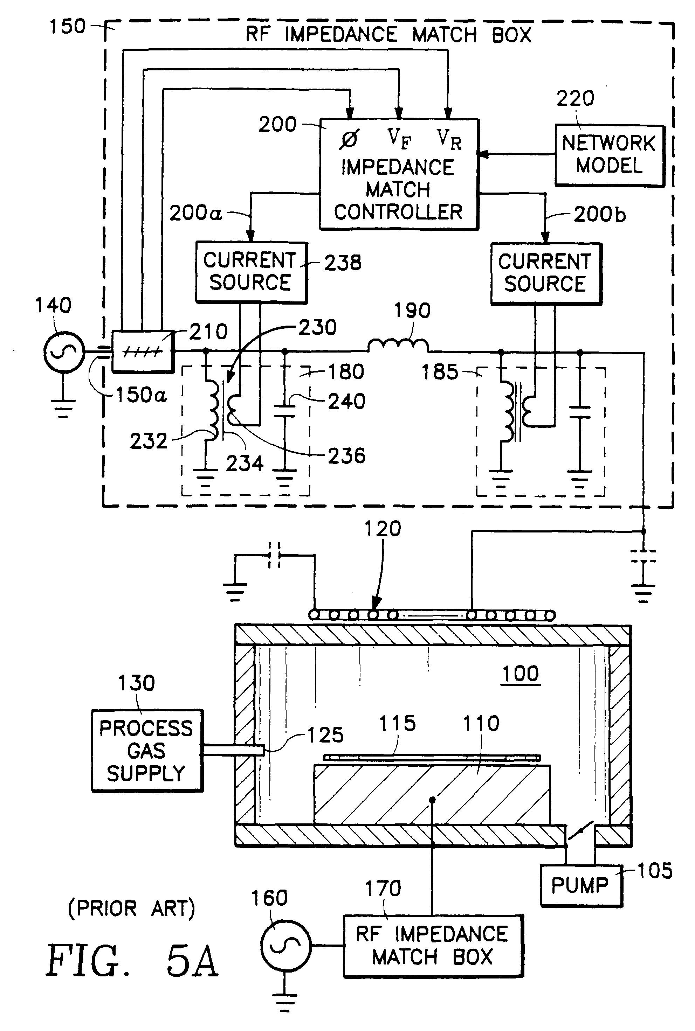

A conventional plasma reactor having such a variable RF impedance match circuit is depicted in FIG. 5A. The plasma reactor includes a reactor chamber 100 evacuated by a pump 105, a wafer support pedestal 110 on which a wafer 115 may be placed, an overhead coil antenna 120, and a gas inlet 125 into the chamber 100 coupled to a process gas supply 130. An RF plasma source signal generator 140 is connected through an RF impedance match box 150 while an RF bias signal generator 160 is connected through another RF impedance match box 170 to the wafer pedestal 110. The power applied by the plasma source signal generator 140 controls plasma ion density in the chamber 100 while the power applied by the bias signal generator 160 controls plasma ion energy near the wafer 115. In some cases, both ends of the coil 120 may be connected to ground through respective capacitors shown in dashed line in FIG. 5A.

The RF impedance match boxes 150 and 170 are generally the same and will be described with reference to the RF impedance match box 150. The impedance match is provided by a conventional "pi-network" consisting of a pair of parallel capacitors 180, 185 (which are really capacitor circuits) on either side of a series inductor 190. Each of the capacitor circuits 180, 185 is controlled by an impedance match controller 200. The controller 200 monitors the forward voltage, reverse voltage and current/voltage phase angle via a conventional directional coupler 210 at the RF input 150a and computes from these three parameters a correction to the capacitance of each variable capacitor circuit 180, 185, using a network model 220. The controller 200 issues control signals at its control outputs 200a, 200b to the variable capacitors 180, 185 to effect the needed corrections in their capacitance values. Each of the variable capacitors 180, 185 can be a mechanically variable capacitor or an electrically variable capacitor circuit as illustrated in the drawing, the latter choice being preferable. FIG. 5A illustrates one example of the latter case, in which each variable capacitor circuit 180, 185 consists of an electrically variable inductor 230 connected in parallel with a fixed capacitor 240. The variable inductor 230 is a saturable reactor consisting of a primary winding 232, a magnetically permeable core 234 and a smaller control winding 236 connected to a variable current source 238. A respective one of the control outputs 200a, 200b is connected to an input of the current source 238. The controller 200 can decrease the capacitance of the variable capacitor 180 by increasing the D.C. or low frequency current through the control winding 236. This in turn reduces the permeability of the core 230 (by inhibiting the magnetic domains in the core from following the field fluctuations in the primary winding 232) and hence reduces the inductance presented by the primary winding 232, thereby decreasing the predominance of the capacitive reactance presented by the fixed capacitor 240 over the inductive reactance. Such a change represents an effective decrease in capacitance of the variable capacitor 180. The reverse process produces an increase in capacitance.

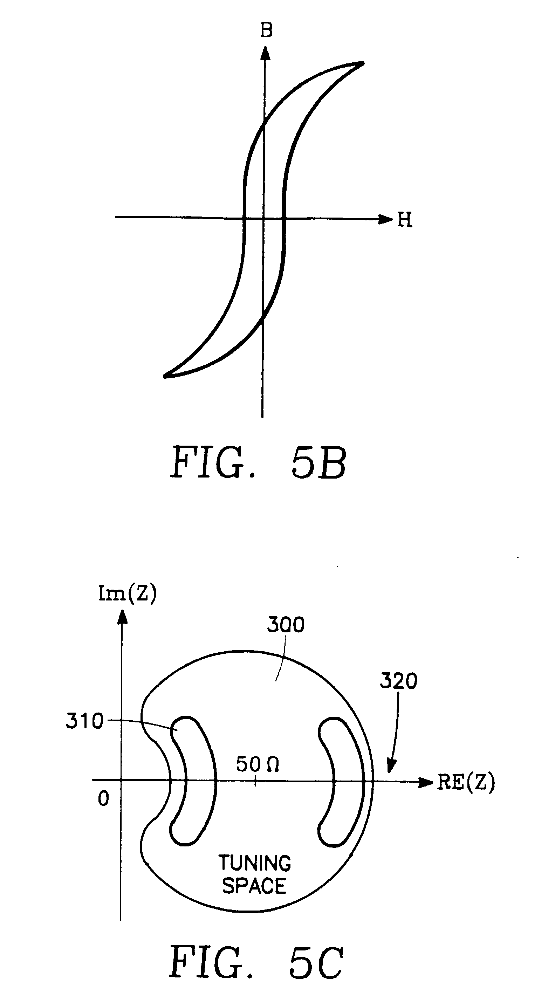

One disadvantage of such a device is that it requires a measurement of the forward and reflected voltages and the phase therebetween, or a measurement of the current and voltage and the phase therebetween. Another disadvantage is that it is bulky and costly. Another more important disadvantage is that there are hysteresis losses in each core 234 that vary as the load impedance varies. Referring to FIG. 5B, as the applied magnetic field H (from the control winding 236) increases and then decreases, the induced magnetic field B that fixes the polarization of the core magnetic domains changes at different rates so that there is a net loss of energy with each cycle of the induced field. Referring to FIG. 5C, the complex impedance plane of the match network includes a tuning space 300 within which the impedance match controller provides a theoretically exact solution to the impedance matching problem. Assuming the signal generator output impedance is a purely resistive $50\Omega$, if the controller 200 commands a higher control current through the control winding 236, it moves the impedance presented by the pi-network 180, 185, 190 to a lower impedance in the region 310 of the control space. In this case the magnetic core 234 fluctuates near the origin of the hysteresis loop of FIG. 5B and the losses are slight. If on the other hand the controller 200 commands a lower control current, the resulting impedance can be found in the region 320 of higher resistance in the control plane, and the fluctuations in the core 234 may reach the outer extreme of the hysteresis loop of FIG. 5B, in which case the losses in the core 234 are very high. Thus, it is seen that the delivered power to the coil antenna 120 will necessarily vary as the plasma-loaded impedance of the coil antenna 120 varies, a significant disadvantage.

Various other impedance match techniques are known in addition to the foregoing. For example, to avoid the problem of load-dependent losses in the saturable reactor cores, the saturable reactors may be discarded in favor of mechanically variable capacitors. However, such mechanically tunable devices are relatively slow and subject to mechanical breakdown. Frequency tuning is a technique in which the RF generator frequency is varied so as to follow the resonant frequency of the plasma-loaded antenna. The main disadvantage of this technique is that, while it does succeed in maintaining the load impedance nearly free of any reactance, it does result in a variation in delivered RF power as the RF generator frequency is changed, due to impedance magnitude mismatch. Another technique is load power servoing, in which the amount of delivered power is monitored, and the RF generator power is varied as necessary so as to maintain the delivered power at a nearly constant level. The disadvantage of this technique is that the power and heat dissipation requirements imposed upon the RF power generating system are greatly expanded, representing an increased cost and bulkiness. Another disadvantage is that it requires the measurement of power, which entails a measurement of voltage, current and the phase between them. The delivered-power servoing technique can be combined with some advantage with the frequency servoing technique.

A more fundamental problem inherent in all of the foregoing conventional techniques is that their controlling parameters (e.g., resonant frequency, delivered power and so forth) are not those directly affecting plasma characteristics controlled by the object (either the overhead coil antenna, electrode or wafer pedestal) to which the RF generator is connected. Specifically, it is the time rate of change of current in the coil antenna which primarily controls plasma density, and it is the bias voltage applied to the wafer pedestal which primarily controls ion energy at the wafer. Thus, the foregoing conventional techniques suffer from the disadvantage that they only indirectly maintain a uniform or constant process profile.

It is an object of the invention to tune the RF generator output to the plasma-loaded coil antenna input (load) while avoiding the foregoing problems. Specifically, the problems to be avoided are mechanically adjustable reactance elements (subject to mechanical failure), load-dependent efficiency variations, bulky magnetic components such as saturable reactors, variations in delivered power with changes in load impedance, the necessity of measuring three parameters (e.g., forward and reverse voltages and phase and/or current, voltage and phase).

It is another object of the invention to provide the foregoing tuning function with reference to parameters directly controlling the most important plasma characteristics, including plasma ion density at the wafer surface and plasma ion energy at the wafer surface.

## SUMMARY OF THE INVENTION

The invention is embodied in an RF plasma reactor for processing a workpiece in a plasma region within a chamber of the reactor, the reactor including an RF power applicator facing the plasma region and having an RF power input terminal, an RF power generator having a fundamental frequency and having an RF power output terminal, an impedance match network connected between the RF generator output terminal and the RF power input terminal of the RF power applicator, the impedance match network having an output impedance at the fundamental frequency related generally to a complex conjugate of a load impedance measurable at the RF power input terminal looking toward the RF power applicator in that its combination with other reactive components with which it is connected provides an impedance which at least nearly approximates the load impedance complex conjugate, and a harmonic impedance element connected between the impedance match network and the RF power input terminal of the RF power applicator, the harmonic impedance element having an impedance at a harmonic frequency of the fundamental frequency which is higher than the impedance of the impedance match network at the harmonic frequency, whereby to isolate harmonic frequencies generated in a plasma sheath near the electrode from the impedance match network.

The RF power applicator can include a workpiece support in the chamber whereby the RF power applicator is capacitively coupled, and the plasma sheath overlies the workpiece. In this case, the reactor can also include an inductive power applicator receiving RF plasma source power, wherein the RF power output connected to the capacitively coupled RF power applicator including the workpiece support constitutes plasma bias power.

The impedance of the harmonic impedance element can have at least one peak magnitude near the harmonic frequency or a peak magnitude over a range of harmonic frequencies. The range of harmonic frequencies can include second and third harmonics of the fundamental frequency. Alternatively, the impedance of the harmonic impedance element can have respective peak magnitudes near respective harmonic frequencies of the fundamental frequency.

Preferably, in accordance with one implementation of the invention, the impedance of the harmonic impedance element near the harmonic frequency(s) is predominantly reactive, having a phase angle near the harmonic frequency at least near $\pm 90°$. In one embodiment, the impedance of the harmonic impedance element near the harmonic frequency is predominantly inductive, having a phase angle near $+90°$.

The fundamental frequency is preferably in a low frequency range wherein ions in the plasma can substantially follow cycling of the RF field in the plasma sheath near the workpiece, and the inductively coupled source power provides a high ion density plasma in the chamber. The upper limit of the low frequency range depends upon sheath thickness (i.e., electron density and electron temperature) and mass of the plasma ions, and therefore may vary with these parameters from as little as on the order of 2 MHz to on the order of 20 MHz.

The impedance match network can include reactive components having fixed values, and the RF generator can include a novel frequency servo loop which maintains an impedance match. Alternatively, the impedance match network can include reactive components of which at least one is variable, and the RF generator can include a conventional servo loop which varies the variable reactive component to maintain an impedance match.

BRIEF DESCRIPTION OF THE DRAWINGS

FIG. 1 is a graph of an ideal time domain waveform of the plasma sheath voltage monitored at the wafer pedestal.

FIG. 2 is a graph of a corrupted (perturbed) time domain waveform of the plasma sheath voltage monitored at the wafer pedestal.

FIG. 3 is a graph of the ion energy distribution corresponding to FIG. 1, wherein the ordinate is the ion energy and the abscissa is the number of ions.

FIG. 4 is a graph of the ion energy distribution corresponding to FIG. 2.

FIG. 5A is a schematic diagram of a plasma reactor including an RF impedance match box of the prior art.

FIG. 5B illustrates the magnetic hysteresis losses in a saturable reactor of the RF impedance match box of FIG. 5A, in which the horizontal axis is the applied magnetic field H and the vertical axis is the induced magnetic field B.

FIG. 5C illustrates a complex plane of the impedance of the RF impedance match circuit in which the real component of impedance is the horizontal axis and the imaginary component is the vertical axis.

FIG. 6 is a simplified schematic diagram of an RF plasma reactor incorporating a preferred embodiment of the present invention.

FIG. 7 is a graph of complex values of the impedance of the chamber measured under various process conditions, in which the vertical and horizontal axes are the imaginary and real parts, respectively, of the impedance.

FIG. 8 is a graph of the complex conjugate of values of the impedance of the combination of the match network and the harmonic impedance element, in which the vertical and horizontal axes are the imaginary and real parts, respectively, of the impedance.

FIGS. 9 and 10 are graphs of the calculated impedance magnitude and phase, respectively, at the RF bias power input terminal of the chamber looking toward the R.F. generator.

FIGS. 11 and 12 are graphs of the calculated impedance magnitude and phase, respectively, as a function of frequency of an RF generator at the generator output terminal looking toward the generator, the generator being one used in a particular implementation of the embodiment of FIG. 6.

FIG. 13 illustrates a variation from the preferred embodiment of FIG. 6 using a fixed frequency in which the impedance match servo governs a variable capacitor in the impedance match network.

FIG. 14 illustrates another preferred embodiment of the invention employing n harmonic impedance elements corresponding to n harmonics of the fundamental bias RF frequency.

FIGS. 15 and 16 are suggestive illustrations of the magnitude and phase, respectively, of the output impedance of the impedance match and harmonic impedance elements in the embodiment of FIG. 14.

FIG. 17A illustrates a first embodiment of a frequency tuning impedance match apparatus capable of carrying out a tuning process of the invention.

FIG. 17B is a graph of the magnitude of a selected measurable parameter (such as delivered power) versus RF generator frequency.

FIG. 17C illustrates a resonant circuit formed by the coil antenna of the reactor and lumped tuning elements.

FIGS. 17D, 17E and 17F illustrate various tuning circuits for driving the wafer pedestal in the reactor of FIG. 17A.

FIG. 18 is a graph illustrating the plasma ion energy distribution at the wafer surface, in which the horizontal axis is ion energy and the vertical axis is number of ions.

FIG. 19 is a diagram illustrating the waveform of the wafer voltage in the reactor of FIG. 17A.

FIG. 20 illustrates a second embodiment of the invention employing a transformer with multiple switched windings.

FIG. 21 illustrates a third embodiment of the invention employing a multi-filar transformer with multiple switched outputs.

FIG. 22 is a block flow diagram illustrating the operational concept of a basic mode of the invention.

FIG. 23 is a block flow diagram illustrating one embodiment of a process carried out by the source signal frequency servo.

FIG. 24 is a block flow diagram illustrating one embodiment of a process carried out by the bias signal frequency servo.

FIG. 25 is a simplified schematic diagram of a preferred embodiment of the invention.

DETAILED DESCRIPTION OF THE PREFERRED EMBODIMENTS

Introduction:

Distortion of the sheath voltage waveform is prevented in the present invention by providing a harmonic impedance element between the chamber and the match network (or "match circuit") offering a particular impedance to the harmonic components of the sheath voltage and current (e.g., the second and third harmonics), while cooperating with the impedance match circuit at the fundamental frequency to provide the desired impedance match. The impedance phase and impedance magnitude of the harmonic impedance element are selected to adjust the phase (and possibly the amplitude) of each one of the harmonics (or at least of the second harmonic or the second and third harmonics) generated in the plasma sheath at least nearly to that required to produce the "normal" half-wave rectified sinusoid sheath voltage waveform of FIG. 1, without significantly impacting the impedance match at the fundamental frequency provided by the match circuit. In most embodiments of the invention, this is accomplished principally by providing in the harmonic impedance element an impedance to the desired harmonic(s) (e.g., second or second and third harmonics) much greater than that provided in the match circuit.

In another more robust and hence more costly embodiment, plural harmonic impedance elements can each provide a particular impedance magnitude and impedance phase to a respective one of many harmonics of the RF signal (for example, up to twenty harmonics), for precise optimization of performance. This embodiment may be particularly advantageous as changing design requirements increase the aspect ratio of the openings to be etched in the workpiece.

At the higher harmonics (e.g., second and/or third harmonics), the impedance of the harmonic impedance element preferably is greater than that of the match circuit, as stated above. This isolates the match circuit from the harmonics generated at the plasma sheath. As a result, the match circuit design is optimized to match a wider range of plasma load impedances at the fundamental frequency without regard to behavior at harmonic frequencies.

In a preferred embodiment of the invention, the harmonic impedance element is principally inductive. It is felt that this provides the requisite phase response at the second harmonic (and of the third harmonic as well) to produce a normal or clean half-wave rectified sinusoidal sheath voltage waveform. Moreover, in accordance with the preferred embodiment, the magnitude of the impedance at the second and third harmonics is relatively high, typically above $50\Omega$. While the preferred embodiment employs an inductive impedance at the second harmonic (and/or third harmonic), it is noted that in any case the RF bias generator output impedance has a large real component, while the chamber load impedance has a small real part and is nearly purely reactive, having an impedance phase angle of either +90 degrees or -90 degrees. Thus, in either case, the harmonic impedance element will best be either capacitive or inductive. The latter is preferred because it is felt that the load impedance of the chamber/plasma/sheath is principally capacitive.

In designing a system including the match circuit and the harmonic impedance element, the match circuit component values are selected while taking the insertion impedance of the harmonic impedance element into account so as to provide an impedance match at the fundamental RF frequency. This match is sufficiently close so as to limit the reflected RF voltage and current to less than 20% and preferably less than 10% across an impedance range encompassing the anticipated variations in load impedance of the plasma or plasma chamber during processing. The component values of the harmonic impedance element are selected to provide a high inductive impedance across a range of second harmonic frequencies. This range is significant if the match circuit employs RF tuning methods which vary the fundamental RF frequency to follow variations in the plasma chamber load impedance.

Preferably, in order to isolate the match circuit from the plasma sheath-generated harmonic frequency components, the harmonic impedance element is placed between the impedance match circuit and the chamber.

In one embodiment in which the workpiece is supported on an electrostatic chuck, the D.C. voltage source driving the electrostatic chuck has its output connected between the bias RF generator output and the match circuit input, in contrast to the usual approach in which the D.C. source output is connected between the match circuit output and the electrostatic chuck. In this embodiment, an inductor in parallel with the usual blocking capacitor is provided through which the D.C. voltage can be applied to the chuck.

For a given circuit topology of the match circuit and of the harmonic impedance element, a computer software program such as MathCad can compute the optimum component values for a given frequency or frequency range of the second and third harmonics, given a certain constraint, such as presenting a large inductive impedance (e.g., typically greater than 50n) to each harmonic or at least to the second harmonic. Such a computation, while straightforward in light of the teachings contained in this specification, take into account the insertion impedance of the harmonic impedance element at the fundamental frequency, the length and characteristic impedance of the various connecting cables and each reactive element.

In the more robust embodiment, the number of harmonic impedance elements (or, equivalently, the number circuit elements in one harmonic impedance element) can be increased to give the computation more degrees of freedom so that each harmonic up to many orders may be individually filtered by providing the optimum impedance at each individual harmonic.

<u>A Plasma Reactor Which Isolates Plasma Sheath Harmonics:</u>

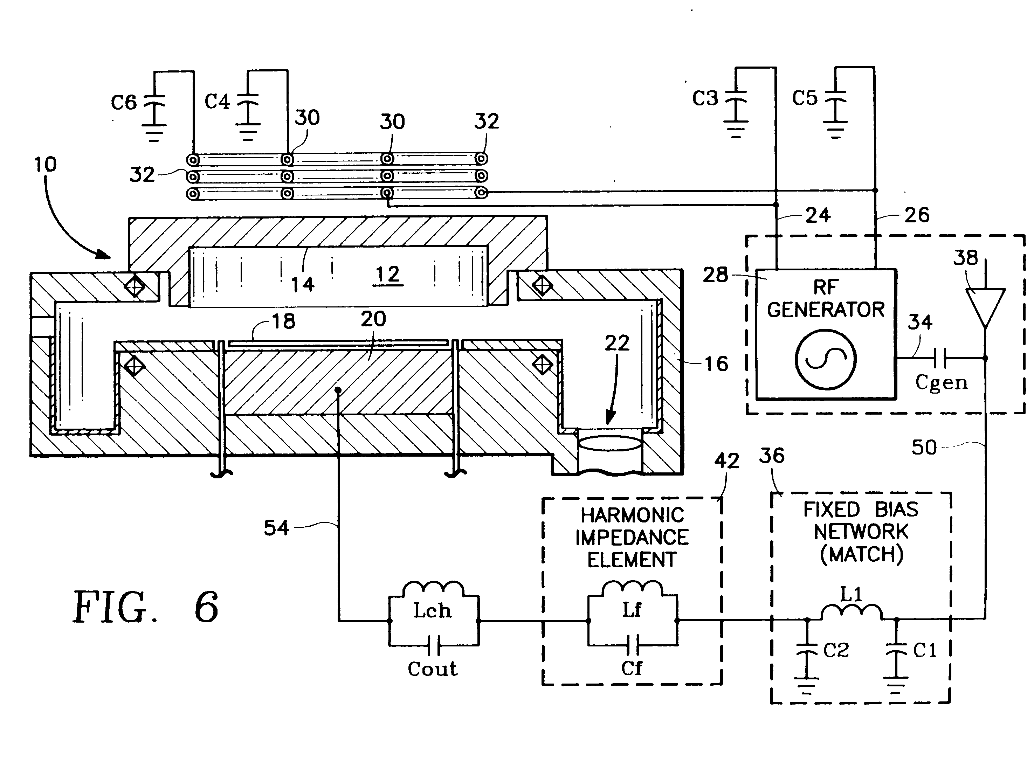

Referring to FIG. 6, a plasma reactor has a chamber 10 defining a plasma region 12 underlying a chamber ceiling 14 and surrounded by a chamber cylindrical sidewall 16. A workpiece 18 (typically a semiconductor wafer) is supported on a wafer pedestal 20, which may be an electrostatic chuck of the type well-known in the art. The interior of the chamber 10 is evacuated to a suitable vacuum through a pumping aperture 22 by a turbopump (not shown).

Plasma source power is applied by two independent RF power generator outputs 24, 26 of an RF generator 28 to respective inner and outer coil inductors 30, 32 overlying the ceiling 14. Plasma bias power is applied by another independent RF power generator output 34 of the generator 28 to the wafer pedestal 20. In a preferred embodiment, the RF generator 28 includes, internally, an impedance match control system employing frequency tuning methods and related parameter servoing methods described in detail below in this specification. In this case, there is a fixed match network associated with each generator output 24, 26, 34.

Specifically, the generator bias output 34 is connected to a fixed match network (or "match circuit") 36 constituting a pi-network consisting of a series inductor L1 flanked by parallel capacitors C1 and C2. The fixed match network of the generator output 24 consists of respective parallel and series capacitors C3, C4 connected with, respectively, the input and output of the inner coil inductor 30. The fixed match network of the generator output 26 consists of respective parallel and serial capacitors C5, C6 connected with, respectively, the input and output of the outer coil inductor 32. However, the present invention is not limited to the use of impedance match circuits employing frequency tuning and or related parameter servoing methods. In fact, the present invention is generally applicable where any sort of impedance match circuit is employed. For example, the impedance match network 36 may not be "fixed" but may be variable instead, and a conventional impedance match controller in the RF generator 28 operates by varying the reactance of one component in the match network 36 (e.g., the capacitor C1 or C2) to follow variations in the plasma chamber load impedance.

A series output capacitor Cout between the match network 36 enhances the function of the harmonic impedance element 42, and may be considered as a part thereof in this analysis. The harmonic impedance element 42 (Cf and Lf) is a parallel resonance tank circuit with resonant frequency near the 3rd harmonic of the fundamental RF frequency from the RF generator output 34. At the fundamental frequency this circuit is inductive and has a higher impedance than the chamber load impedance. In order to match the chamber load impedance at the fundamental frequency, the match impedance must be reduced. For this purpose, the capacitor Cout is connected in series with the harmonic impedance element 42 and at the fundamental RF frequency range (e.g., 1.5-1.9 MHz) substantially reduces the match impedance of the entire network taken as a whole (i.e., all the match components including the fixed network 36 and the harmonic impedance element 42). This is because the capacitor Cout and the inductive tank circuit of the harmonic impedance element 42 create a series resonance circuit with resonant frequency below the fundamental RF frequency range. The combination of the fixed matching network 36 (a pi-network), the fixed harmonic impedance element 42 with the series capacitor Cout permits matching to a complex (real and imaginary) chamber load impedance which may vary between a low magnitude (e.g., 10 Ohms) under certain process conditions and a high magnitude (e.g., 180 Ohms) under other process conditions, while simultaneously presenting a high impedance magnitude to second and third (and higher) harmonics of the RF fundamental frequency. This is an important advantage because the same reactor can be employed to carry out different processes having different complex chamber load impedances, such as an etch process characterized by one complex chamber load impedance and a chamber clean operation (with the production wafer on the pedestal 20) characterized by a different complex chamber load impedance. The etch process is typically carried out with combination etchant and polymer precursor gases (e.g., fluorohydrocarbons) while the chamber clean operation is typically carried out with an oxygen gas.

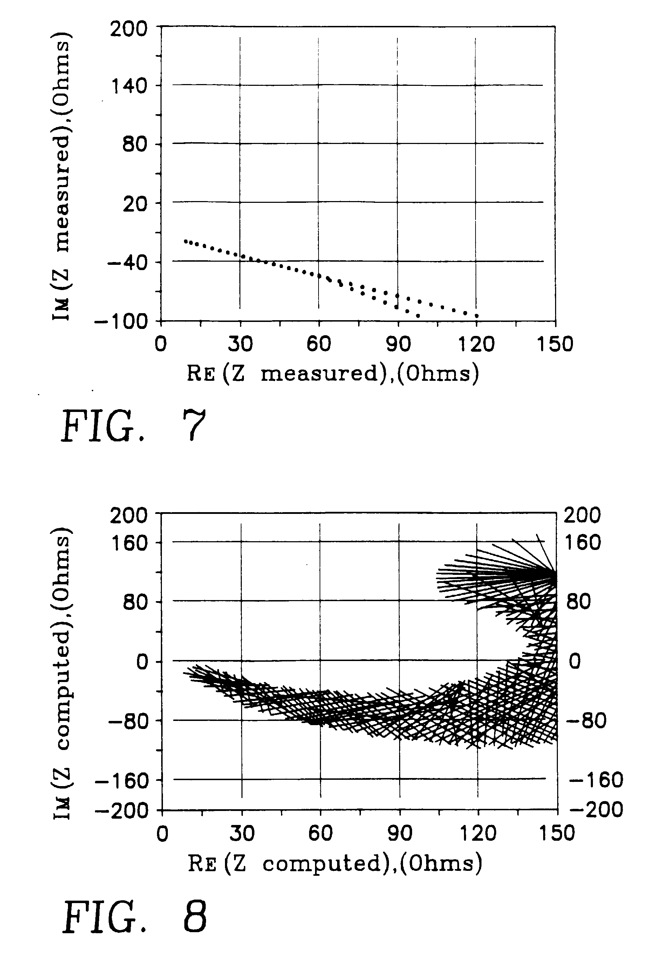

The magnitude of the complex chamber load impedance is a function of several parameters including the plasma source power level, the plasma bias power level, the chamber pressure, the gas composition, the frequency of the plasma source power generator and the frequency of the plasma bias power generator. The chamber load impedance magnitude at the wafer-pedestal electrode increases with plasma bias power level and decreases with plasma source power level. Since the same chamber can operate at different values of each of the foregoing parameters, its chamber load impedance can range over a large space in the complex plane as illustrated in the graph of FIG. 8 discussed to later in this specification.

Because Cout is connected in series between the harmonic impedance element and the wafer pedestal, no D.C. current can flow to the pedestal, unless another current path is provided. Such a D.C. current is necessary is the wafer pedestal 20 is an electrostatic chuck of the type well-known in the art requiring the application of a charging and discharging D.C. current to control the loading and unloading of the production wafer on the pedestal 20. For this purpose, typically an electrostatic chuck (ESC) driver 38 which provides the D.C. control voltage to the electrostatic chuck or pedestal 20 has its output connected between the capacitor Cout and the ESC pedestal 20. However, in the preferred embodiment of the present invention, an ESC driver 38 has its output connected between the generator output 34 and the fixed match network 36. A capacitor Cgen in series between the generator output 34 and the output of the ESC driver 38 prevents D.C. current flow from the ESC output 38 to the generator 28. A choke inductor Lch in parallel with the output capacitor Cout permits D.C. current flow from the ESC driver 38 to the ESC pedestal 20. The inductive reactance of the choke inductor Lch is sufficiently high so that, at the fundamental and harmonic frequencies of the bias power generator, it allows D.C. current flow therethrough but virtually no RF current flow. The advantage of this arrangement is that the RF generator 28 and the ESC driver 38 can be integrated.

## Harmonic Impedance Element:

Isolation of the fixed match network 36 from the plasma sheath-generated harmonics is achieved in accordance with the present invention by a harmonic impedance element 42 at the output of the fixed impedance match network 36. As set forth above, the harmonic impedance element 42 should present a higher impedance to harmonics generated in the plasma sheath than is presented by the match network 36. In the embodiment of FIG. 6, the harmonic impedance element 42 consists of a parallel filter capacitor Cf and a parallel filter inductor Lf. The fixed impedance match network 36, in combination with the impedances connected to it (including the insertion impedance of the harmonic impedance element 42), provides an output impedance which, at the fundamental RF frequency of the generator 28, is nearly the complex conjugate of the input plasma chamber impedance at the wafer pedestal 20. The harmonic impedance element 42 provides an impedance which, at various harmonics of the fundamental, is generally higher than the load impedance of the plasma chamber. Generally, at these harmonics, the harmonic impedance element 42 has a greater impedance than that of the match network 36.

## Anticipated Range of Chamber Load Impedance

The range of load impedances of an exemplary RF plasma reactor chamber was determined by measuring the load impedance at the connection of the cable 54 to the wafer pedestal 20 for each one of a succession of different process conditions (i.e., different pressures, gas flow rates and gas types, RF power levels, RF frequencies and chamber pressures) under which the chamber is intended to be used. The results of this series of measurements are represented in FIG. 7 as points in a complex plane of real and imaginary impedance components (horizontal and vertical axes). These points describe a two-dimensional space of measured impedance values. The impedance match network must provide a impedance which is sufficiently close to the complex conjugate of the chamber load impedance so that reflected power is limited to a certain maximum ratio of the total power (for example, 30%-50%, or preferably 20% or more preferably 4%).

## Design Method:

In selecting the component values of the various capacitors and inductors in the RF signal path from the generator 28 to the pedestal 20, the values of the components Cf and Lf of the harmonic impedance element 42 are first selected to provide the desired high inductive impedance over the anticipated range of at least the second harmonic, and preferably over the range of the third harmonic as well. The range of the fundamental in an implementation of the embodiment of FIG. 6 was 1.5 Mhz to 1.9 Mhz. Once this is established, the insertion impedance of the harmonic impedance element 42 is readily determined and taken into account in selecting the component values of fixed impedance network 36, namely C1, C2 and L1. These latter component values are selected to provide an impedance which is generally close to the complex conjugate of the plasma chamber load impedance (as measured at the wafer pedestal 20) for an anticipated range of plasma chamber load impedances. To optimize the range of the circuit, the impedance of the fixed impedance network 36 is selected so that the total output impedance (presented by all the circuit elements Cgen, C1, C2, L1, Cf, Lf, Cout, Lch and the cables 50, 54, all taken together as a whole) is generally the complex conjugate of an impedance near the middle of the range (or space) of load impedances (as depicted in FIG. 8, for example). As described separately below, as the load impedance wanders away from its middle range, a corresponding mismatch with the fixed impedance network 36 is minimized or at least nearly avoided by servoing the bias RF generator frequency appropriately.

This design method was implemented using Math-Cad software. The fixed conditions were as follows: the cable 50 from the RF generator output 34 to the input of the fixed match network 36 was 96 feet long, the cable 54 between the output stage (Cout and Lch) and the wafer pedestal 20 was 3 feet and both cables 50, 54 were coaxial with characteristic impedances of 50Ω; the tuning frequency range of the bias RF fundamental frequency was 1.5 Mhz to 1.9 Mhz; the plasma/sheath load impedance at cable connection to the wafer pedestal 20 was confined to the space depicted in FIG. 8; the fixed impedance element was required to have an impedance generally corresponding to the complex conjugate of the load impedance of FIG. 7; and, the harmonic impedance element 42 (Cf and Lf) was required to provide a very high inductive impedance at the second and third harmonics of the bias RF fundamental frequency. This led to the following component values:

$$C1 = 1.15 \cdot 10^{-8} \text{ farads}$$

$$C2 = 5.7 \cdot 10^{-9} \text{ farads}$$

$$L1 = 2.2 \cdot 10^{-6} \text{ henries}$$

$$Lf = 2 \cdot 10^{-6} \text{ henries}$$

$$Cf = 6.8 \cdot 10^{-10} \text{ farads}$$

$$Cout = 2.36 \cdot 10^{-9} \text{ farads}$$

$$Lch \approx 100 \cdot 10^{-6} \text{ henries}$$

Results:

FIG. 8 illustrates a two-dimensional space in the complex plane of real and imaginary components (horizontal and vertical axes) of the complex conjugates all possible complex impedance values presented by the impedance match network (i.e., the network comprising Cgen, C1, C2, L1, Cf, Lf, Cout and the cables 50, 54) across the fundamental frequency range (e.g., 1.5 to 1.9 MHz) and across a range of reflected power from zero to 4%. The impedance values in the graph of FIG. 8 were computed using MathCad software. FIG. 8 clearly shows that the space of impedance values is more than sufficiently large to cover the entire space of measured impedance values of FIG. 7. Therefore, the impedance match network of FIG. 6 is adequate to constrain the reflected RF power within the desired limit (e.g., 4%).

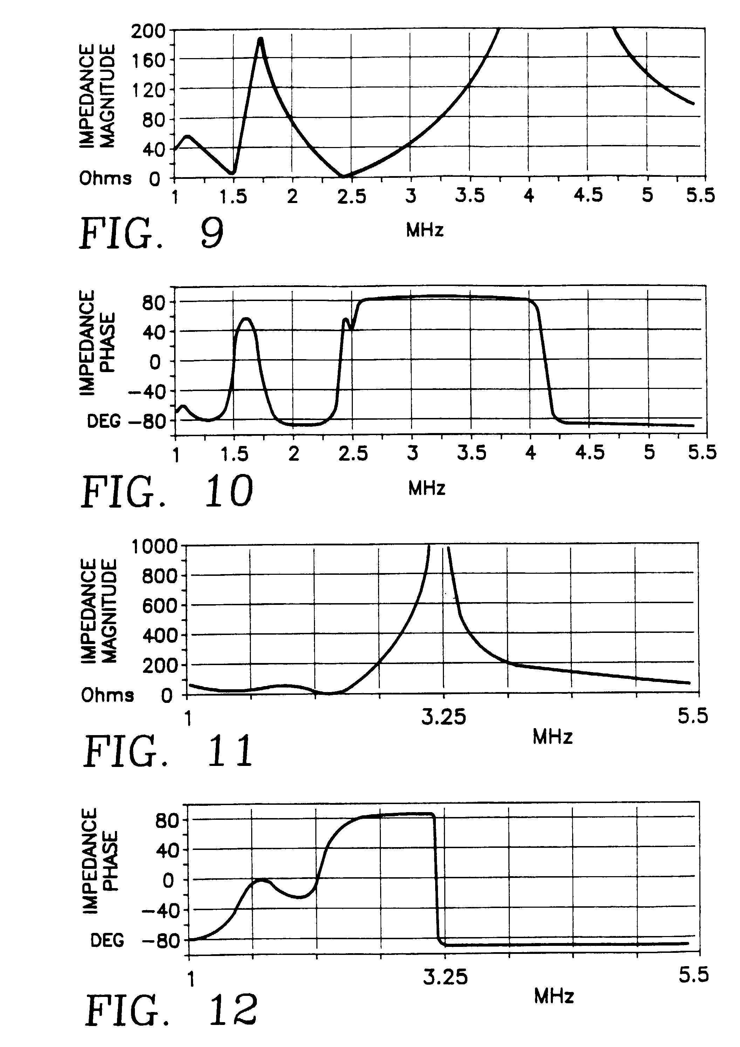

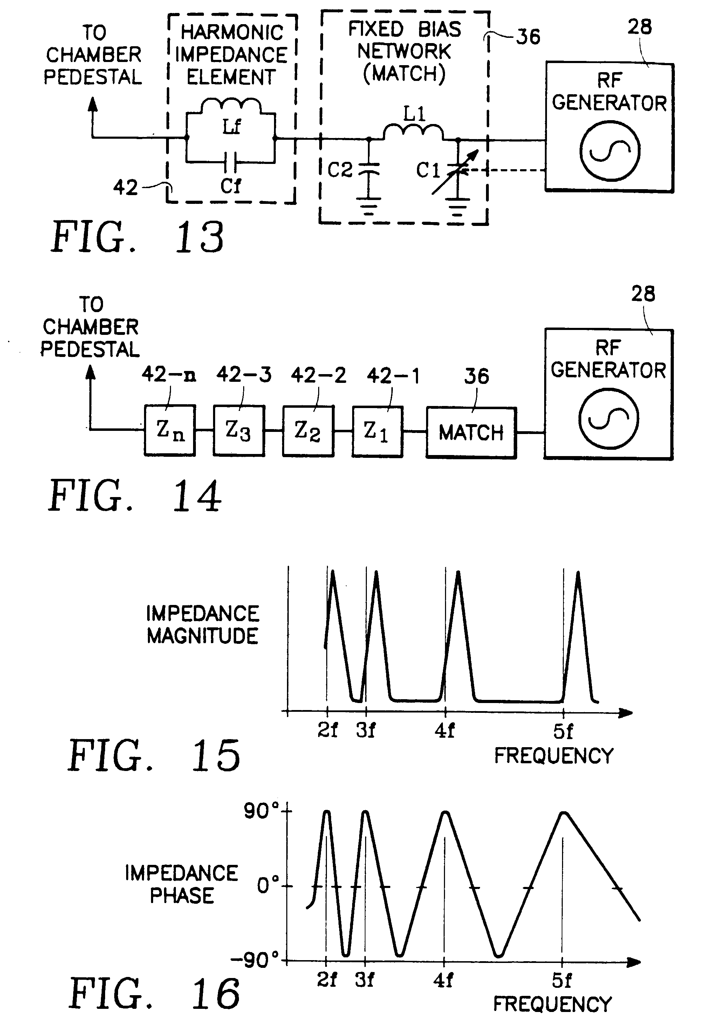

The foregoing component values provided a calculated output impedance as measured at the wafer pedestal end of the cable 54 looking toward the RF generator 28 whose magnitude and phase are as illustrated in FIGS. 9 and 10 respectively. FIG. 9 indicates that the output impedance was about 60n in the middle of the range of the second harmonic and well over 200n in the middle of the range of the third harmonic, while FIG. 10 shows that at the second harmonic at least, the phase of the output impedance was generally inductive, and nearly 90 degrees, as desired. The calculation of the impedance illustrated in FIGS. 9 and 10 depends (typically only slightly) upon the magnitude and phase of the measured output impedance of the bias output of the RF power generator 20, and will therefore vary depending upon the choice of generator. The magnitude and phase of the generator output impedance in the embodiment of FIG. 6 used in calculating the match output impedance illustrated in FIGS. 9 and 10 is illustrated in FIGS. 11 and 12.

Better results can be obtained by adding more reactive components to the system to provide more degrees of freedom in the computation. For example, a higher impedance at the second harmonic and a broader band across which the phase is close to 90 degrees.

In a preferred way of carrying out the invention, the first step is to insert the harmonic impedance element 42 and select its impedance to be near a match at the second and third harmonics, and the second step is to take account of all impedances, including that of the cables 50 and 54, and select the impedance of the fixed impedance network 36 to be nearly a complex conjugate of the middle of the range of the load impedance.

The most important result in the performance of the embodiment of FIG. 6 is that the etch stopping problems associated with the sheath voltage waveform of FIG. 2 are eliminated, and the sheath voltage waveform assumes the form of FIG. 1. Another important result is that the impedance match range for the bias RF signal is increased. This is because the optimization of the component values of the fixed match circuit 36 (e.g., by the MathCad software) in accordance with the foregoing method takes into account impedance at the fundamental frequency only, which provides the widest possible impedance match range at the fundamental frequency. This method is made possible by the isolation of the harmonics generated in the plasma sheath from the impedance match network 36. In contrast, lack of such isolation in the prior art dictated an impedance match circuit design which had to provide some compensation at the harmonic frequencies, thereby forcing a compromise of performance at the fundamental frequency, including a loss of impedance match range. This advantage is the same whether a conventional RF impedance match technique (using a variable reactance in the impedance match circuit) is employed or whether the frequency tuning impedance match technique described herein (where the match network 36 is fixed) is employed. In the latter case, an advantage of the invention is that the frequency tuning range is not constricted by effects arising from the harmonics generated in the plasma sheath.

FIG. 13 illustrates a variation of the embodiment of FIG. 6 in which the harmonic impedance element 42 is employed in combination with an impedance match technique in which an impedance match servo inside the RF generator 28 varies the capacitance of the capacitor C1 in the match network 36.

FIG. 14 illustrates a robust embodiment of the invention in which there are plural (i.e., n) harmonic impedance elements 42-1 through 42-n (wherein n is an integer greater than 1) connected in series between the impedance match network 36 and the output capacitor Cout. The impedance of each one of the harmonic impedance elements 42-1 through 42-n is selected to peak at a respective one of the harmonic frequencies generated in the plasma sheath, up to any number (n) of harmonics. For example, the first twenty harmonics can be dealt with in this fashion, to provide the best possible performance and cleanest possible sheath voltage waveform. One possible illustrative example of the magnitude and phase of the impedance presented by the series array of harmonic impedance elements 42-1 through 42-n is suggested in the graphs of FIGS. 15 and 16, respectively. In FIG. 15, there is a peak at each harmonic frequency. In FIG. 16, the phase peaks near +90 and -90 degrees between resonances of the match circuit and is approximately 0 degrees near each resonance. The impedance magnitude peaks preferably occur near corresponding resonances of the match circuit. There are three choices in this design: (1) The circuit resonance may be slightly above the frequency of the corresponding harmonic, in which case the impedance phase at the harmonic frequency is inductive, or (2) slightly below in which case the phase is capacitive, or (3) is at the same frequency, in which case the impedance has a significant resistive component. If the first choice is taken, then, each harmonic frequency coincides with a falling edge of the phase, which starts at +90 degrees, so that the impedance presented at each harmonic is predominantly inductive. However, as referred to previously in this specification, a capacitive impedance in the harmonic impedance element 42 may be desirable instead, depending upon the particular chamber design and plasma process conditions produced therein.

We believe the invention is particularly adapted to a plasma reactor of the type illustrated in FIG. 6 in which a relatively low bias RF frequency is employed (e.g., around a few MHz) and an inductive source power applicator is used to produce a plasma having a high plasma ion density. A relatively low bias RF frequency applied to the wafer pedestal 20 may be defined as one in which the plasma ions in the sheath can respond to the cycling of the bias RF signal, albeit with less mobility than the electrons, as described above. A relatively high plasma ion density refers to a plasma ion density distribution typically achieved with an inductive coil coupling the plasma source power into the plasma region 12, with ion densities on the order of, for example, at least $10^{10}$ ions per cubic centimeter and higher (e.g., on the order of $10^{11}$ - $10^{12}$ ions per cubic centimeter).

Frequency Tuning and Parameter Servoing:

The preferred embodiment of the invention employs a feature described in the above-referenced application which tunes the RF generator output to the signal applicator load by servoing the RF frequency so as to optimize a characteristic of the plasma, such as plasma ion density or ion energy at the wafer. This is accomplished by servoing the frequency in accordance with a measured parameter (power, voltage or current) directly related to the plasma characteristic to be optimized. The frequency is servoed within a range until the parameter's magnitude reaches an optimum value (which is either a minima or a maxima within that frequency range, depending upon the parameter). The invention also controls an output magnitude of the RF signal generator (e. g., output power, output current or output voltage) so as to further optimize the same RF parameter or optimize another RF parameter. For an inductively coupled signal applicator (such as a coil antenna), the plasma characteristic to be optimized is typically plasma ion density, and the relevant parameter(s) may be reflected power at the generator output (which is optimum when at a minima), or delivered power or current flow (I) or time rate of change of the current (dI\dt) through the signal applicator or the product of current and frequency (any of which is optimum when at a maxima). For a capacitively coupled signal applicator (such as an electrode), the plasma characteristic to be optimized can be either plasma ion density (if the electrode is radiating plasma source power) or ion energy (if the electrode is radiating bias power, as in the case of a wafer pedestal-electrode). In this case, the relevant parameter(s) can be reflected power, delivered power, reflected voltage or delivered voltage or a Fourier component or other function of the voltage or current. If the parameter selected for frequency control is delivered power, then the foregoing tuning process constitutes impedance matching. In the case of a parameter to be controlled at the wafer-pedestal electrode, the parameter may be the voltage of the wafer measured by A.C. coupling (e.g., across an electrostatic chuck dielectric layer) or by D.C. coupling (by a voltage probe contacting the wafer itself), as will be discussed later in this specification.

In operation, a frequency servo control loop and a generator output magnitude (power, voltage or current) servo control loop are employed. At first, the frequency control loop overcomes a very large initial impedance mismatch by seeking the RF generator output frequency at which the parameter (such as, for example, the parameter dI\dt, the time rate of change of the current through an inductive plasma source signal applicator) reaches a local maximum value within the specified frequency range. Once this is accomplished, or at least nearly accomplished, the other control loop can begin operating while the frequency control loop continues to operate. Together, the two control loops optimize the desired plasma characteristics despite changing load conditions on the RF signal applicator. Such changing load conditions are typically attributable to subtle changes inside the reactor chamber (e.g., on-going deposition of materials on chamber walls and so forth).

Such frequency tuning can fail to completely optimize the selected parameter. For example, it can leave a mismatch between load and output impedance magnitudes even after reaching the optimum frequency. Therefore the servo control loop governing the signal generator output magnitude (of output power, output current or output voltage) --which may be referred to as a secondary control loop-- provides further optimization. Preferably, the secondary control loop adjusts the output power of the RF generator to set and maintain the selected parameter (or another parameter) at a desired set point or magnitude.

The invention can, in certain embodiments, tune the frequency so as to regulate the plasma characteristic which is to be controlled. Take for example, one plasma characteristic, namely plasma ion density: Plasma ion density is a function of the following measurable parameters: plasma source power (i.e., an inverse function of reflected power and a function of delivered power) at the plasma source signal generator output; time rate of change (dI/dt) of current flow in the inductive signal applicator, or, equivalently for sinusoidal waveforms, the product of the current flow (I) and the frequency. Since the invention servos the frequency so as to optimize these parameters, it directly controls the desired plasma characteristic (e.g., plasma ion density), a significant advantage.

A similar analysis holds true with respect to another plasma characteristic, namely ion energy at the wafer: Ion energy at the wafer is a function of the following measurable parameters: bias power (an inverse function of reflected power and a function of delivered power at the bias generator output); wafer voltage (which is typically sensed in an AC-coupled measurement across an electrostatic wafer chuck). The wafer voltage itself is a function of the delivered voltage at the bias generator output and an inverse function of the reflected voltage at the bias generator output. Since the invention servos the frequency so as to optimize these latter parameters, it directly controls the desired plasma characteristic (e. g., ion energy), a significant advantage.

Frequency Servoing of the Plasma Source Power:

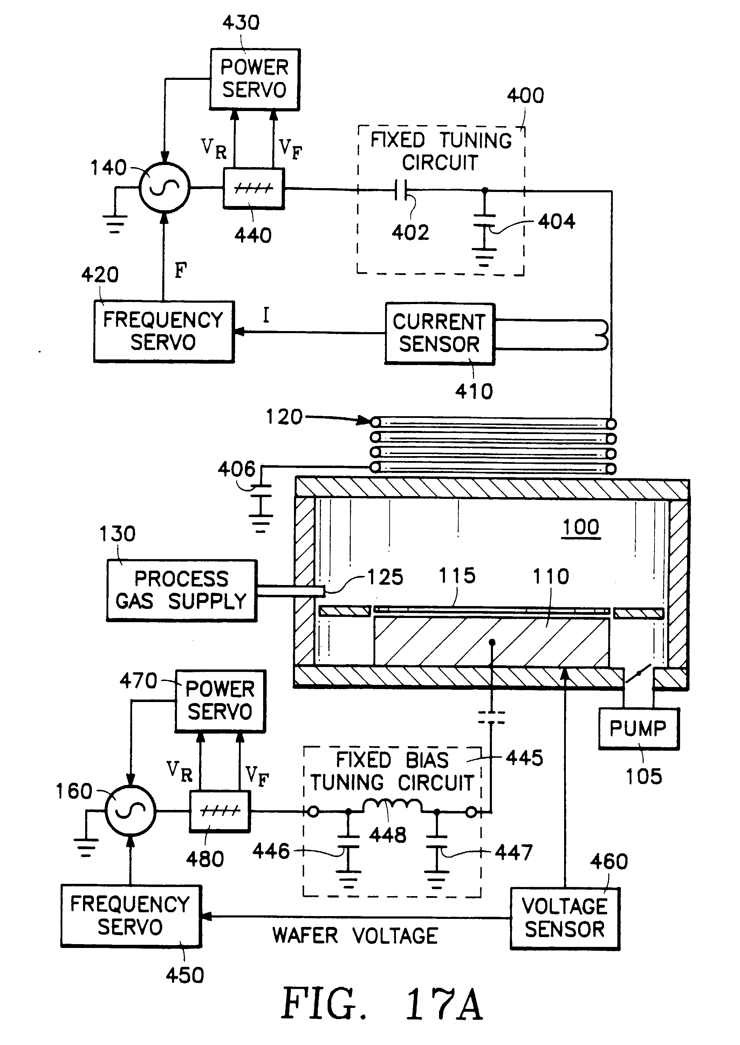

In the embodiment illustrated in FIG. 17A, the RF plasma source signal applicator 120 is an inductive applicator in the form of a coil antenna or solenoid. The invention is also useful in a reactor employing a capacitive electrode as a plasma source signal applicator. The RF plasma source signal generator 140 has a variable or controllable frequency and is connected to the coil antenna 120 through a fixed tuning network 400 consisting of reactive elements such as (optionally) a series capacitor 402, a parallel capacitor 404 and/or a series capacitor 406, although any suitable fixed tuning circuit may be employed. These capacitive elements, together with the inductive coil antenna 120, provide a LC tuning network. A current sensor 410 monitors the RF current to the coil antenna 120. A frequency servo 420 periodically samples the coil antenna current sensed by the current sensor 410 and uses that information to control the frequency of the RF source signal generator 140. The frequency servo 420 may be designed to implement a control method. For example, the frequency servo 420 may comprise an integrated circuit microprocessor programmed to carry out the control method. The skilled worker may choose from among many suitable circuit topologies other than those shown in FIG. 17A for balancing the antenna.

In general, this control method is such that the RF source signal frequency is servoed so as to optimize the one plasma characteristic primarily controlled by the plasma source power, namely plasma ion density. In general the plasma ion density is affected by the current (I) in the coil antenna and more specifically by the magnitude of the time rate of change in the coil antenna current (dI\dt). Thus, the process controls the plasma source signal frequency so as to optimize either the coil antenna current, or more preferably to optimize the magnitude of the change in the coil antenna current (dI\dt) or the product of the current (I) and the RF frequency.

In a first embodiment of this process, the frequency servo 420 changes the frequency of the generator 140 in response to changes in the coil antenna current in such a way as to maximize the coil antenna current with respect to frequency within a range from a low frequency to a high frequency and then maintain this optimum condition thereafter despite subtle slow variations in the load impedance. Such variations are caused by relatively gradual changes in the plasma process conditions (arising from, for example, the deposition or removal of polymer and/or other material on the chamber walls).

In a second embodiment of this process, the frequency servo 420 changes the frequency of the generator 140 in response to changes in the coil antenna current in such a way as to optimize the time rate of change (dI\dt) in coil antenna current with respect to frequency within a frequency range from a low frequency to a high frequency. In one version of this embodiment, the frequency servo 420 changes the frequency so as to maximize the product of the coil antenna current (I) multiplied by the RF frequency (F) with respect to frequency within a frequency range from a low frequency to a high frequency. Since the coil current generally has a sinusoidal form, the product I·f is at least a good approximation of dI/dt.

In a third embodiment of this process, the frequency servo 420 changes the frequency of the generator 140 in response to changes in the delivered or reflected power (as measured at the signal output of the generator 140) in such a way as to maximize the delivered power or minimize the reflected power, within a frequency range from a low frequency to a high frequency.

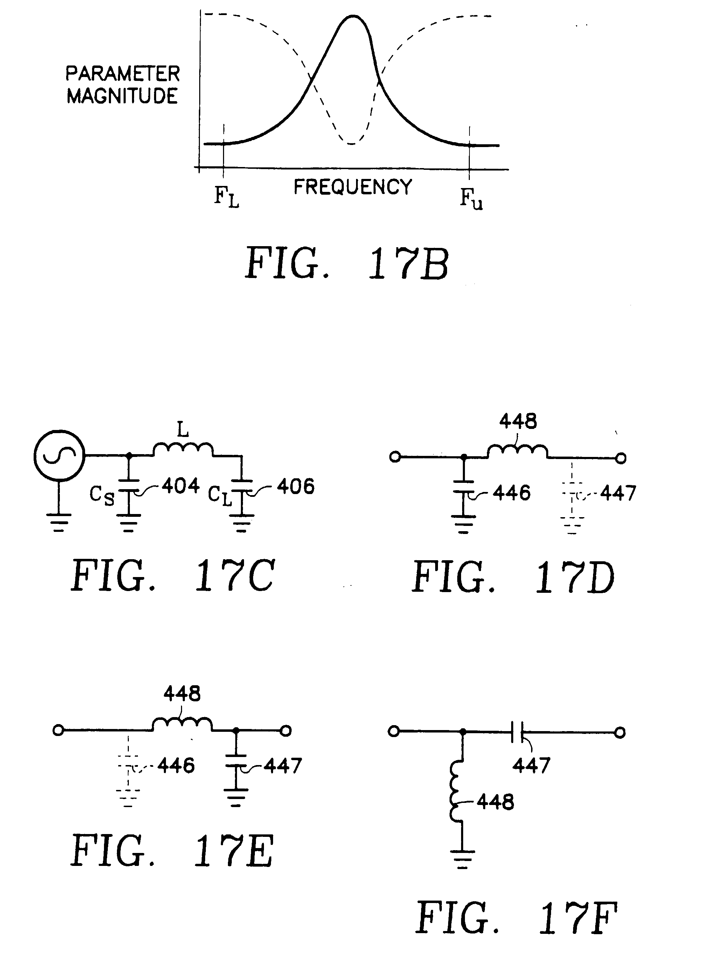

FIG. 17C illustrates a general tuning circuit which includes the inductance L of the coil antenna 120, the capacitance $C_S$ of the parallel capacitor 404 and the capacitance $C_L$ of the series capacitor 406 at the grounded end of the coil antenna 120. The capacitances $C_S$ and $C_L$ are chosen to resonate the coil within the source power frequency range and to provide an appropriate impedance magnitude relatively close to the source power generator output impedance. Preferably, the manner in which Cs and Cl are connected to the coil antenna is chosen as illustrated in FIG. 17C so that the voltage on the winding nearest the chamber ceiling is lowest (to minimize capacitive coupling tot he ceiling or plasma). Many different circuit arrangements besides the ones disclosed above may be employed in carrying out the invention.

Power Servoing of the Plasma Source Power:

As discussed previously herein, frequency servoing can leave a mismatch between the magnitudes of the load and output impedances, leading to some reflected power. In order to compensate for such reflected power losses, a power servo 430 shown in FIG. 17A controlling the signal output level of the generator 140 monitors the forward and reflected RF voltages ($V_F$ and $V_R$ respectively) sensed at the output of the source signal generator 140 via a directional coupler 440, to determine delivered power. The power servo 430 changes the output power of the generator 140 so as to maintain one of the measured parameter mentioned hereinabove (such as, for example, the delivered RF power, current, time rate of change of current or the product of current x frequency) at or near a desired set point. The power servo 430 may comprise an integrated circuit microprocessor programmed to carry out this function.

FIG. 17B is a graph of the magnitude of a selected parameter versus frequency, depicting in solid line the behavior of a selected parameter (such as delivered power or inductive coil current rate of change) which is to be maximized. Note that within a limited frequency range the parameter exhibits a local maximum, which the frequency servo 420 seeks. This graph also depicts in dashed line the behavior of another parameter (such as reflected power) which is to be minimized. Within the limited frequency range, this other parameter exhibits a local minimum, which the frequency servo 420 seeks.

In order to minimize unnecessary power adjustments by the power servo 430, the power servo 430 could be disabled until the frequency servo 420 has servoed the selected parameter to within a predetermined threshold maximum level (or minimum level, depending upon the parameter type). This ensures that when a very large out-of-tune condition or mismatch exists (for example, when the system is first turned on), the frequency servo 420 operates by itself to seek an approximate initial tune condition or match before the power servo 430 increases the RF power to compensate for any residual impedance magnitude mismatch. This reduces the initial amount that the power servo 430 increases the RF power. This feature is readily implemented by the skilled worker in a variety of ways. For example, the system may be programmed to not enable the power servo 430 until the frequency servo 420 had achieved a predetermined percentage improvement (e.g., an increase) in the magnitude of the selected parameter from an initial magnitude.

Frequency Servoing of the Bias Power:

Referring again to FIG. 17A, the bias signal generator 160 is connected to a bias signal applicator, which is typically the wafer pedestal 110, through a fixed bias tuning circuit 445 consisting of reactive elements such as capacitors and/or inductors. A D.C. blocking capacitor (indicated in dashed line) may be connected between the pedestal 110 and the circuit 445. Ideally, the frequency of the RF bias signal generator 160 driving the wafer pedestal 110 is servoed in such a manner as to optimize the one plasma parameter primarily controlled by the bias power applied to the pedestal 110, namely the wafer voltage. This voltage may be, for example, the negative peak voltage or the D.C. bias level of the wafer voltage (i.e., the D.C. component of the wafer voltage). The peak wafer voltage is an estimate of the peak ion energy at the wafer surface, while the wafer D.C. bias level of the wafer voltage is an estimate of the average ion energy at the wafer surface.

Implementation of the wafer pedestal 110 as an electrostatic chuck ("ESC") may prevent direct (DC-coupled) measurement of the wafer voltage. This is because an ESC has a dielectric layer supporting and insulating the wafer from the ESC. In this case, some component of the AC-coupled measurement of the wafer voltage can be measured to provide an indication of the true wafer voltage.

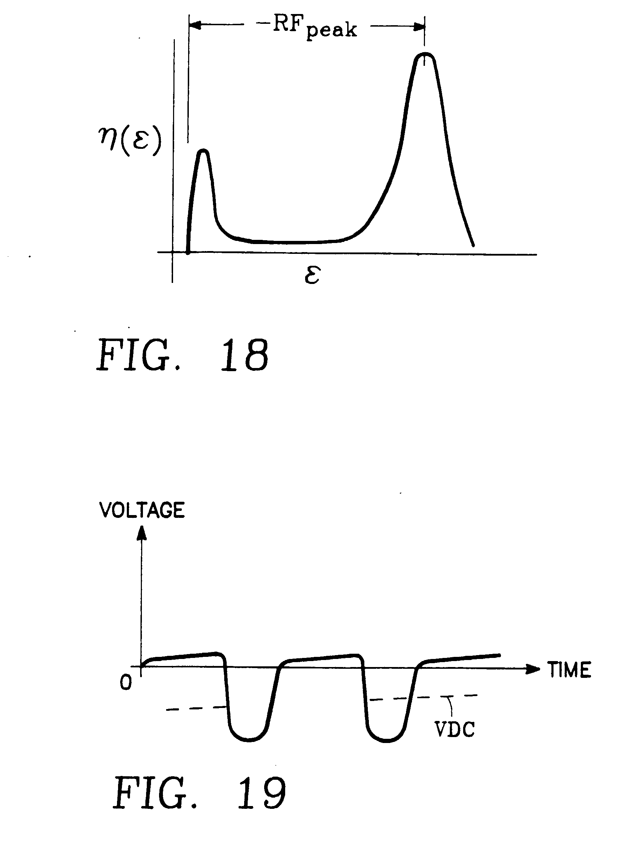

For example, if it is desired to optimize the D.C. bias level of the wafer voltage, then the parameter can be a Fourier component (e.g., the first or second harmonic) of the voltage measured at the wafer pedestal. In this case, the bias power frequency is servoed so as to maximize a quantity related to the D.C. bias voltage (which might not be directly measurable, as mentioned above), such as a selected component of the pedestal or wafer voltage (measured via A.C. coupling) with respect to frequency over a range of frequency from a low frequency to a high frequency. This component may, for example, be a harmonic (e.g., second harmonic) of the voltage. As referred to above, the wafer voltage may be measurable only through A.C. coupling, so that its D.C. bias level is not directly measurable. However, the D.C. bias voltage of the pedestal (or semiconductor workpiece or wafer) may be estimated using techniques well-known in the art. As will be discussed below with respect to FIGS. 18 and 19, the pedestal voltage waveform is similar to a half-wave rectified wave form, and it is well-known that the D.C. bias level of a half-wave rectified sinusoidal waveform may be computed from certain Fourier components of a half-wave rectified sinusoidal waveform. In the present case, to the extent the pedestal or wafer voltage is similar to a half-wave rectified waveform, its D.C. bias may be estimated from its Fourier components.

In accordance with another embodiment of the invention, the wafer voltage may be measured directly by D.C. coupling via a voltage probe directly contacting the wafer. In this embodiment, either the D.C. coupled negative peak wafer voltage or the D.C. coupled bias level of the wafer voltage is sensed and can be used as the parameter to be optimized by frequency or parameter servoing. Alternatively, the parameter can be a Fourier component of the D.C. coupled wafer voltage. Or, the parameter can be a function of such Fourier components.

In an alternative embodiment, the frequency of the RF bias signal generator 160 driving the wafer pedestal 110 is servoed in such a manner as to maximize delivered power or minimize reflected power (as measured at the signal output of the bias signal generator 160) within a range of frequencies from a low frequency to a higher frequency.

In carrying out the preferred process, a bias power frequency servo 450 controlling the output frequency of the RF bias signal generator 160 responds to the output of a voltage sensor 460 connected to the wafer pedestal 110. The bias power frequency servo 450 performs a process in which the wafer voltage is decomposed into a particular component and the bias frequency is servoed to maximize that component. The bias frequency servo 450 may comprise an integrated circuit microprocessor programmed to carry out that process.

The fixed bias tuning circuit 445 in general can be an L-network, or it may be a pi-network (as shown in the drawing) consisting of a pair of parallel capacitors 446, 447 connected across each side of a series inductor 448. FIG. 17D shows how the capacitor 447 can be eliminated if the real part of the load impedance of the plasma-loaded coil antenna 120 is less than the real part of the output impedance of the RF bias generator 160. FIG. 17E illustrates how the capacitor 446 can be eliminated if the real part of the load impedance is greater than that of the generator 160. FIG. 17F illustrates how the circuit of FIG. 17E may be reversed to achieve the same result. The pi-network 445 of FIG. 17A is preferred if the plasma-loaded antenna input impedance can vary above or below the generator output impedance. In general, any suitable tuning circuit topology may be employed in carrying out the invention.

FIG. 18 illustrates the distribution of plasma ion energy, in which the vertical axis is number of ions while the horizontal axis is ion energy. There are two peaks, one at a low ion energy and one at a higher ion energy. The shape of the distribution illustrated in FIG. 18 tends to change with various conditions including RF bias power frequency. FIG. 18 is typical for a high density plasma at low electron temperature (for a thin plasma sheath) at an RF bias frequency sufficiently low so that most of the plasma ions traverse the sheath in a single RF cycle and where the cathode and anode have different effective areas and the voltage is that measured at the smaller electrode. FIG. 19 illustrates the behavior of the voltage of the plasma-immersed wafer, the voltage having a waveform somewhat similar to a half-wave rectified sinusoidal voltage. It is the higher voltage peak which predominantly governs the plasma ion energy near the wafer surface. In other words, the plasma ion energy distribution of FIG. 18 is affected by the wafer voltage of FIG. 19 and in particular by the higher peak voltage thereof. By controlling the bias power frequency to control the peak of the wafer voltage waveform of FIG. 19 (or a component thereof), the ion energy distribution of FIG. 18 is controlled, thus controlling the plasma ion energy. For certain applications, such as those employing a higher RF bias frequency, it may be better to control the D.C. bias voltage rather than the peak voltage.

Power Servoing of the Bias Power:

As discussed with reference to the source power frequency servo 420, frequency servoing does not compensate for a mismatch in impedance magnitude, and this is true in the case of frequency servoing of the bias signal generator 160. In order to provide such compensation in the case of the bias signal generator 160, a bias power servo 470 receives forward and reflected voltages at the generator output from a directional coupler 480 connected in series with the generator output.

The power servo 470 changes the output power of the bias generator 160 so as to set and maintain a selected parameter (such as the wafer voltage or the delivered bias power) at a desired set point. It should be noted that the servo 470 may not necessarily servo the generator power but may instead servo a generator output parameter other than power, such as output current or output voltage, and thus may be a generator current servo or a generator voltage servo rather than a power servo.

Power Servoing with Switches and Multiple Transformers:

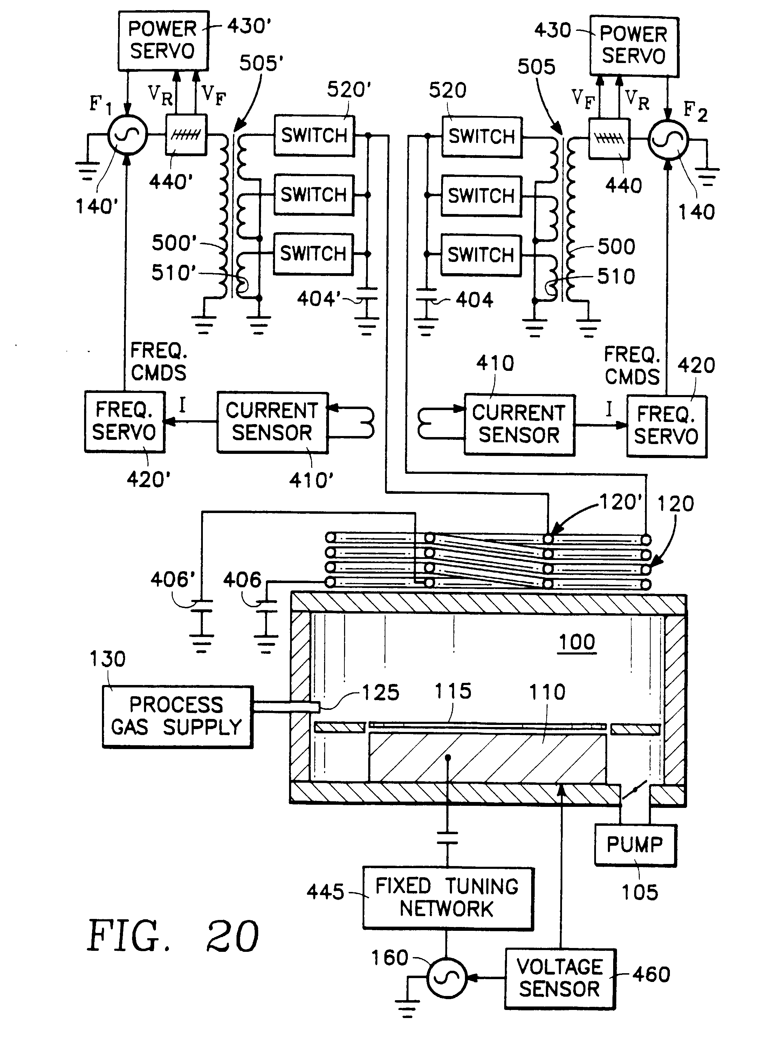

In order to facilitate the impedance magnitude mismatch compensation performed by the plasma source power servo 430, an RF transformer may be connected in series between the source signal generator 140 and the coil antenna 120 having a transformer ratio suitable for compensating for the resistance mismatch. For example, the transformer ratio can correspond to the middle of the anticipated range of resistance mismatch between the generator 140 and the load impedance presented by the tuning network 400 and the plasma-loaded coil antenna 120 for a particular plasma process. FIG. 20 illustrates this concept. In FIG. 20, the source signal generator 140 is connected to a primary transformer winding 500 of a transformer 505 while the coil antenna 120 is connectable to any one of several secondary windings 510 providing different transformer ratios through respective RF switches 520. Each secondary winding provides a ratio suitable for a particular plasma process for which the reactor may be used. Depending upon the process to be performed next, the appropriate one of the RF switches 520 is closed while the others remain open. Alternatively, some combination of the switches 520 can be closed to provide $2^n$ choices of resistance matching ranges, where n is the number of secondary windings and RF switches therefor. Each of RF switches 520 may be a PIN diode, a saturable reactor or a mechanical switch or relay, as but several examples of expedients well-known in the art.

The various inductive and capacitive elements (e. g., the capacitors 404, 406 or the individual capacitive and/or inductive elements of the tuning circuit 445) may be fixed or they may be individually switched or variable (e.g., motorized). Even if these elements are variable, they are set to particular values to which they remain fixed for the duration of a given process step, so that the tuning they provide is a fixed tuning. Thus, for example, (referring to FIG. 17A) the tuning circuit 445 is a fixed tuning circuit for a given process step. Generally, the various inductive and capacitive elements are selected for approximate resonance within a certain frequency range for an approximate or near RF tune condition (or impedance match) at various points within the frequency range. Then, as plasma load conditions vary, the frequency servo loop (e.g., 450) and the magnitude (i.e, power, voltage or current) servo loop (e.g., 470) maintain the near RF tune condition. Likewise, the switches 520 may be set during the entire plasma processing to an optimum setting for a certain set of plasma processing conditions, the system then relying on the frequency and magnitude servo loops (450 and 470) to compensate for changes plasma load conditions.

FIG. 20 illustrates how the same type of multiple ratio transformer with multiple RF switches is employed in the same manner to provide multiple selectable transformer ratios between the bias RF signal generator and the wafer pedestal.

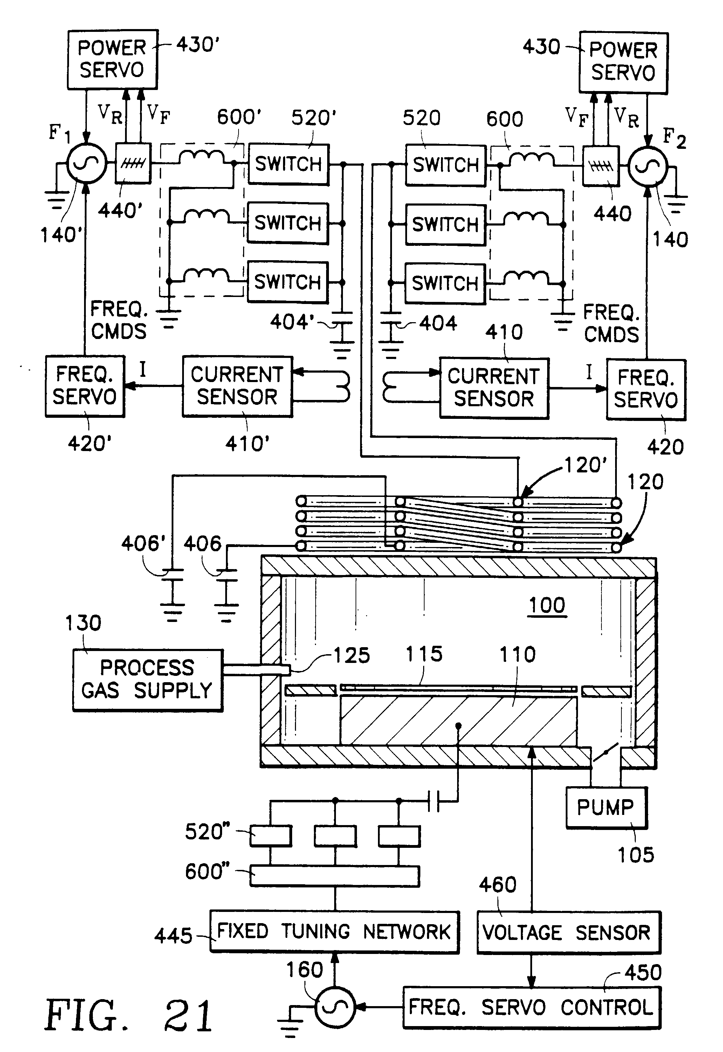

FIG. 21 illustrates the preferred implementation of this concept, in which the different transformer ratios are provided by different windings of the same multi-filar transmission line transformer ("balun"). Thus, each transformer 505, 505' (of FIG. 20) is replaced in FIG. 21 by a conventional multi-filar transmission line transformer 600, 600' with plural windings. Optionally, series capacitors may be added in the manner indicated in dashed line in FIG. 21. FIG. 21 illustrates schematically the conventional topology of the multi-filar transmission line transformers 600, 600', which is well-known in the art and need not be discussed further in this specification.

FIG. 21 also illustrates how an identical multi-filar transmission line transformer 600" with multiple RF switches 520" is employed in the same manner to provide selectable transformer ratios between the bias signal generator 160 and the wafer pedestal 110. While FIG. 21 illustrates an embodiment in which the switches and transformer 520", 600" are connected to the output side of the fixed tuning circuit 445, the switches and transformer 520", 600" may instead be connected to the input side of the fixed tuning circuit (i.e., between the fixed tuning circuit 445 and the generator 160). Furthermore, the switches and transformer 520", 600" may constitute inductive elements of the fixed tuning circuit 445.

Preferably, the tuning capacitor 404 is placed on the output side of the transformer 600 so that the resonance point does not shift with the switching of the switches 520.

As illustrated in FIG. 20, a second coil antenna 120' concentric with and surrounded by the coil antenna 120 may be provided and connected to its own independent source power supply 140' through its own match circuit/transformer 500', 505', 510', 404', 406', 410', 420', 430', 440'. The ranges of the frequencies F1, F2 of the source signal generators 140, 140' are preferably mutually exclusive and are exclusive of the frequency range of the bias signal generator 160. Thus, in a preferred embodiment, the invention employs three mutually exclusive frequency ranges, one for each of the generators 140, 140' and 160. In one embodiment, the range of the bias signal generator 160 is from 1.5 to 1.9 MHz, the range of the source signal generator 140 is from 1.9 to 2.1 MHz and the range of the source signal generator 140' is from 2.2 to 2.4 MHz.

Frequency Servoing Control Algorithms:

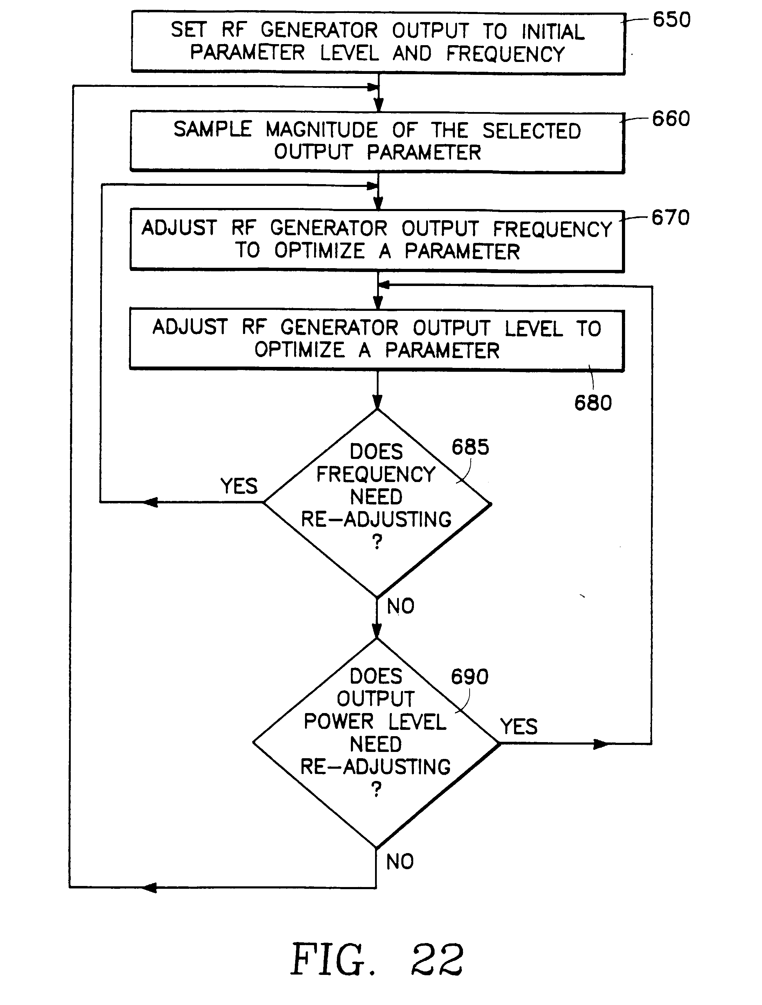

FIG. 22 is a flow diagram illustrating a basic concept of the operation of the invention. This first step in the operation (block 650 of FIG. 22) is to set the RF generator output to an initial power level and frequency. The next step (block 660) is to sample the magnitude of the selected parameter. As discussed hereinabove, this parameter may be one measured at the generator output such as the reflected power, the delivered power, the reflected or forward voltage or the phase angle therebetween, the reflected current, the forward current or the phase angle therebetween or the voltage and current and the phase therebetween or a Fourier component of the voltage or current. Or, this parameter may be one measured elsewhere, such as the current flowing in the inductive coil antenna or its time rate of change or its product with RF frequency, or the wafer pedestal voltage or some Fourier component of the pedestal voltage. The next step (block 670) is to adjust the frequency so as to optimize one of these parameters. As but a few examples, the phase difference between two related parameters (e.g., the current and voltage) may be minimized, or the reflected power may be minimized, or the delivered power or voltage may be maximized, and so forth. Having at least nearly met the desired goal of the second step, the final step (block 680) is to adjust the generator signal output level to maintain the magnitude of the same parameter or another one of the above-listed parameters at a desired set point. Thereafter, if there is an impedance (e.g., phase) mismatch (block 685) the step of block 670 is repeated, and if the selected parameter's magnitude wanders from the desired set point (block 690), the step of block 680 is repeated.

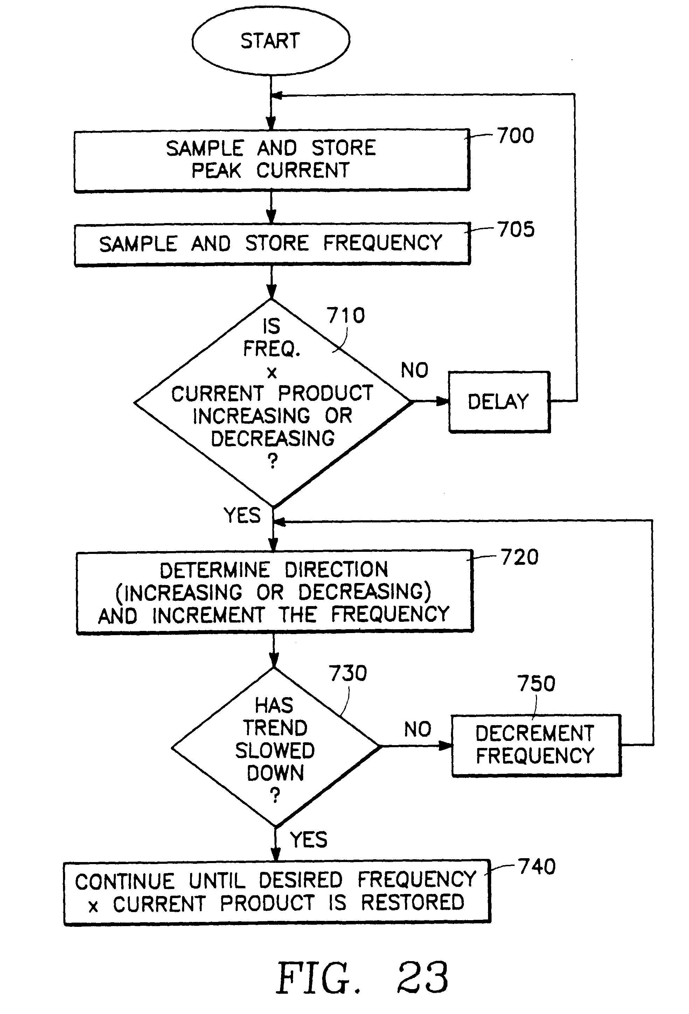

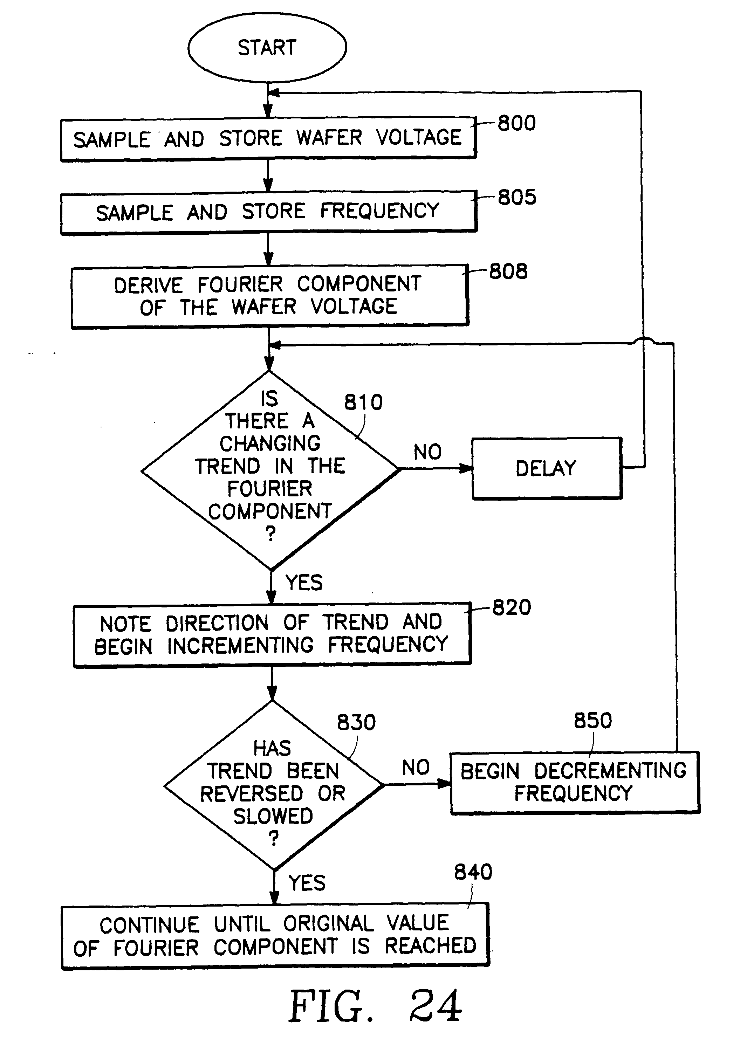

FIGS. 23 and 24 are flow diagrams illustrating the processes carried out by the source power frequency servo 420 and the bias power frequency servo 450, respectively. Referring to FIG. 23, the source power frequency servo periodically samples and stores a certain parameter which, in the following example, is the peak magnitude of the RF current sensed by the current sensor (block 700). (The selected parameter may be any one of the parameters listed previously herein.) It simultaneously stores the corresponding (current) value of the RF frequency of the generator and computes a current-frequency product, which it stores (block 705). The servo then determines from the last n current-frequency products whether there is an upward or downward trend in the current-frequency product exceeding a predetermined threshold of difference over n sample times (block 710). If no such trend is detected (NO branch of block 710), the process delays and returns to the initial step of block 700. Otherwise, if such a trend is detected (YES branch of block 710), then the servo notes the direction of the trend (increasing or decreasing products over time) and begins incrementing the RF frequency in uniform steps (block 720). The servo then determines whether the trend of increasing or decreasing frequency products has been slowed down (or even reversed) after a predetermined number m of sample times (block 730). If so (YES branch of block 730), the servo continues incrementing the RF frequency until the frequency-current product is restored to within a predetermined tolerance of its desired value (block 740). Returning to block 730, if incrementing the RF frequency does not slow down the detected trend (NO branch of block 730), the servo begins decrementing the RF frequency until the frequency-current product is restored to within a predetermined tolerance of its desired value (block 750).

Referring to FIG. 24, the bias power frequency servo periodically samples and stores a certain parameter which, in the following example, is the magnitude of the wafer voltage sensed by the voltage sensor (block 800), and then bases its control upon a related parameter, which in the following example is a selected Fourier component of the wafer voltage. (As in the example of FIG. 23, the selected parameter of FIG. 24 may be any one of the parameters listed previously herein and the control may be based either upon the parameter itself or upon a selected function of that parameter, such as a Fourier component.) The frequency servo simultaneously senses the corresponding (present) value of the RF frequency of the bias generator, which it stores (block 805). The servo then derives, for the current sample time, a Fourier component of the wafer voltage based upon k previously stored samples thereof (block 808). The servo then determines from the Fourier components of the last n sample times whether there is an upward or downward trend in the Fourier component exceeding a predetermined threshold difference over the n sample times (block 810). If no such trend is detected (NO branch of block 810, the process delays and returns to the initial step of block 800. Otherwise, if such a trend is detected (YES branch of block 810), then the servo notes the direction of the trend (increasing or decreasing samples of the Fourier component over time) and begins incrementing the RF frequency in uniform steps (block 820). The servo then determines whether the trend of increasing or decreasing samples has been slowed down (or even reversed) after a predetermined number m of sample times (block 830). If so (YES branch of block 830), the servo continues incrementing the RF frequency until the Fourier component is restored to within a predetermined tolerance of its desired value (block 840). Returning to block 830, if incrementing the RF frequency does not slow down the detected trend (NO branch of block 830), the servo begins decrementing the RF frequency until the Fourier component is restored to within a predetermined tolerance of its desired value (block 850).

While the methods or algorithms of FIGS. 23 and 24 used the polarity of the change in magnitude between successive samples of the parameter to deduce the needed direction of change in frequency, in some applications an alternative is to infer the direction of the needed change in frequency from the sign of a phase angle, such as the sign of the phase angle between the voltage and current at the generator output.

Preferably, the values of the fixed elements such as reactances in the tuning circuit 400 (FIG. 17A) and the ratio of the transformer 600 (FIG. 21) are selected to provide an ideal match at the typical operating conditions of the process to be performed. Typically, the plasma-loaded impedance on the coil antenna, for example, is quite predictable for a given process, so that the fixed values are readily selected to provide a close impedance match. The plasma is preferably ignited using the bias RF power on the wafer pedestal to produce a weak capacitively coupled plasma. After plasma ignition, source power is applied to the coil antenna, thereby causing the plasma ion density to increase toward a level at which the plasma-loaded impedance at the antenna begins to approximate the normal operating conditions for which the match circuits were designed. After normal plasma ion density has been achieved, the difference between the plasma-loaded antenna impedance and the match conditions of the fixed components will be relatively small, and are readily compensated by the operation of the frequency servo.

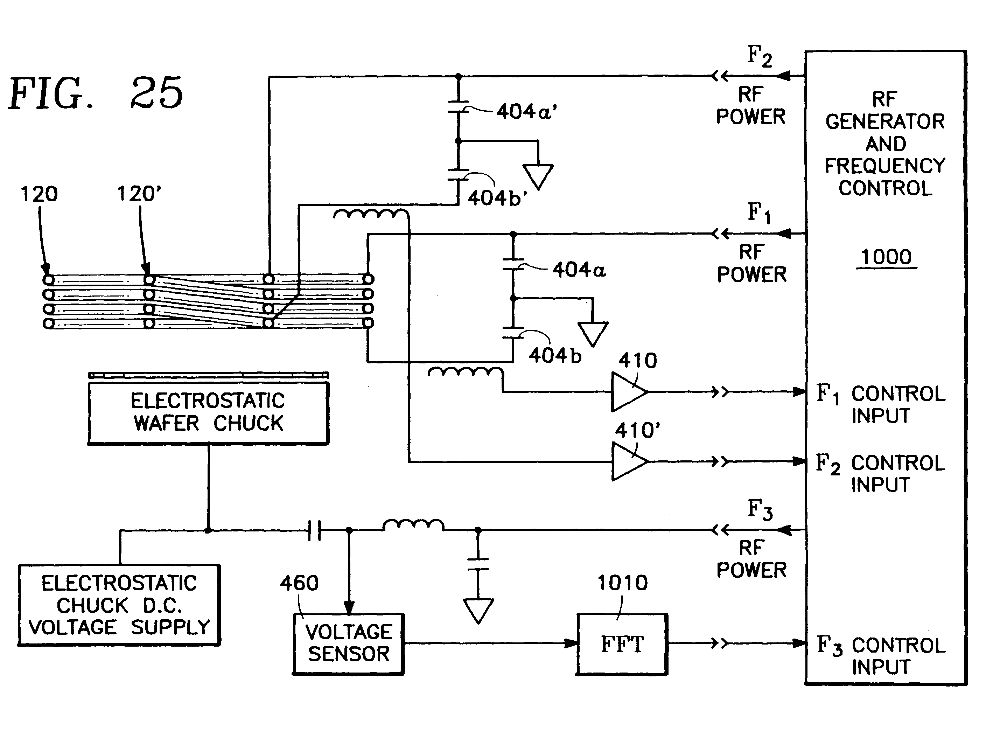

Referring now to FIG. 25, the RF signal generators 140, 140' and 160 (FIG. 20, 21) with respective output frequencies F1, F2 and F3 connected to the outer and inner solenoids and the wafer pedestal respectively may be provided in a single RF generator system 1000 of the type commercially available. The plasma source power frequency servos 420, 420', the bias power frequency servo 450, the plasma source power servos 430, 430' and the bias power servo 470 (FIGS. 20 and 21) are programmed as software modules within the RF generator system 1000. The inner and outer coils 120', 120 are coupled to the generator outputs through capacitive pi-networks formed by the capacitor pairs 404a, 404b and 404a', 404b', respectively. The voltage sensor output from the wafer pedestal voltage sensor 460 is processed in a fast Fourier transform circuit 1010 to provide a selected Fourier component of the pedestal voltage, as described above. Many different parameters may be selected in carrying out the invention in the embodiment of FIG. 25. This is because the commercially available generator system includes, for each RF output, a directional coupler or sensor which can measure at least one of the following sets of parameters measured at the generator outputs: forward and reverse power, load voltage, load current and the phase angle therebetween, forward and reverse voltage and the phase angle therebetween. One practical (but not necessarily preferred) choice would be to servo the delivered source power or delivered bias power.

The invention adjusts the source or bias RF signal generator frequency to optimize a selected RF generator parameter measured at the generator output or at the RF power applicator. The invention also adjusts an RF generator parameter other than frequency, which may be the selected RF generator parameter or another RF generator parameter, to optimize the same or another RF generator parameter. The term "RF generator parameter" includes delivered voltage, delivered current, delivered power, reflected power, time rate of change of current, the product of current $\times$ frequency, a Fourier component of the voltage or current, the phase angle between the voltage and current, or the phase angle between any other two parameters, any of which may be measured at the RF signal generator output or at the RF signal applicator (the coil antenna, wafer pedestal or an electrode) or anywhere along the transmission line between them. It may do all of this simultaneously at two or more signal applicators, such as the bias RF signal applicator (e.g., the wafer pedestal) and the source RF signal applicator (e.g., the coil antenna).

In some cases, the frequency servo may be eliminated, or its role at least reduced. For example, if the plasma-loaded impedance of the signal applicator changes very little over the anticipated range of required plasma processing conditions, then the range of frequencies over which the frequency servo loop operates may be reduced. In fact, it may be reduced to zero, provided the plasma processing conditions vary so little that the combination of the fixed tuning circuit and the signal applicator are never taken out of resonance or near-resonance. For this purpose, the skilled worker may select a fixed tuning circuit which, in combination with the plasma-loaded signal applicator, has a relatively broad resonance band centered at a selected frequency. As described above in this specification, the fixed tuning circuit may consist of either lumped inductive and/or capacitive elements (in the manner of a circuit or discrete elements) or distributed inductive and/or capacitive elements (in the manner of a transmission line). The inductive and/or capacitive values of the fixed tuning circuit are selected so that the combination of the fixed tuning circuit and the plasma-loaded signal applicator operate at or near resonance at a selected RF frequency. In the ideal case in which the frequency servo can be eliminated, this resonance or near-resonance obtains over the entire range of plasma processing conditions. Whether operation is sufficiently near resonance can be evaluated with respect to a number of conditions: (a) whether the VSWR limits of the signal generator at the power level of interest are exceeded, or (b) whether the voltage or current limitations on the signal applicator are exceeded. The latter condition can arise due to a high voltage being induced in the signal applicator which could cause conductor-to-conductor arcing or cause excessive sputtering damage by capacitive coupling to the plasma. The latter condition can also arise due to a high current being induced in the signal applicator which could cause $I^2R$ losses.

While the invention has been described in detail by specific reference to preferred embodiments, it is understood that variations and modifications thereof may be made without departing from the true spirit and scope of the invention.

## Claims

1. An RF plasma reactor for processing a workpiece in a plasma region within a chamber of said reactor, said reactor comprising:

   an RF power applicator facing said plasma region;
   an RF power generator having a fundamental frequency;
   an impedance match network connected between said RF power generator and said RF power applicator; and
   a harmonic impedance element connected between said impedance match network and said RF power applicator, wherein:
   (a) said harmonic impedance element having an impedance at said fundamental frequency such that said impedance match network in combination with said harmonic impedance element provides at least an approximate impedance match at said fundamental frequency with a load impedance of said chamber,
   (b) said harmonic impedance element having an impedance at a harmonic frequency of said fundamental frequency higher than the impedance of said impedance match network at said harmonic frequency, whereby to isolate harmonic frequencies generated in a plasma sheath near said electrode from said impedance match network.

2. The reactor of Claim 1 wherein said RF power applicator comprises a workpiece support in said chamber whereby said RF power applicator is capacitively coupled, and said plasma sheath overlies said workpiece.

3. The reactor of Claim 2 further comprising an inductive power applicator receiving RF plasma source power, wherein said RF power generator furnishes plasma bias power to said capacitively coupled RF power applicator.

4. The reactor of Claim 1 wherein said impedance of said harmonic impedance element has at least one peak magnitude near said harmonic frequency.

5. The reactor of Claim 1 wherein said impedance of said harmonic impedance element has a peak magnitude over a range of harmonic frequencies.

6. The reactor of Claim 5 wherein said range of harmonic frequencies include second and third harmonics of said fundamental frequency.

7. The reactor of Claim 1 wherein said impedance of said harmonic impedance element has respective peak magnitudes near respective harmonic frequencies of said fundamental frequency.

8. The reactor of Claim 4 wherein said impedance of said harmonic impedance element near said harmonic frequency is predominantly reactive, having a phase angle near said harmonic frequency at least near $\pm 90°$.

9. The reactor of Claim 8 wherein said impedance of said harmonic impedance element near said harmonic frequency is predominantly inductive, having a phase angle near $+90°$.

10. The reactor of Claim 5 wherein said impedance of said harmonic impedance element near said second and third harmonics is predominantly reactive, having a phase angle near said harmonic frequency at least near $\pm 90°$.

11. The reactor of Claim 10 wherein said impedance of said harmonic impedance element near said second and third harmonics is predominantly inductive, having a phase angle near $+90°$.

12. The reactor of Claim 7 wherein said impedance of said harmonic impedance element near said respective harmonic frequencies is predominantly reactive, having a phase angle near said harmonic frequency at least near $\pm 90°$.

13. The reactor of Claim 12 wherein said impedance of said harmonic impedance element near said respective harmonic frequencies is predominantly inductive, having a phase angle near $+90°$.

14. The reactor of Claim 3 wherein said fundamental frequency is in a low frequency range wherein ions in said plasma can substantially follow cycling of the RF field in the plasma sheath near said workpiece, and said inductively coupled source power provides a high ion density plasma in said chamber.

15. The reactor of Claim 14 wherein said low frequency range encompasses frequencies on the order of about 2 MHz.

16. The reactor of Claim 1 wherein said impedance match network comprises reactive components having fixed values, and said RF generator comprises a frequency servo loop which maintains an impedance match.

17. The reactor of Claim 1 wherein said impedance match network comprise reactive components of which at least one is variable, and said RF generator comprises a servo loop which varies said variable reactive component to maintain an impedance match.

18. The reactor of Claim 1 further comprising an output capacitor connected between said harmonic impedance element and said RF power applicator.

19. The reactor of Claim 18 wherein said workpiece support comprises an electrostatic chuck, said reactor further comprising a D.C. control voltage source for said electrostatic chuck connected between said RF power generator and said impedance match network, said reactor further comprising a choke inductor connected in parallel with said output capacitor, said choke inductor comprising a path for D.C. current from said D.C. control voltage source to said electrostatic chuck.

20. The reactor of Claim 19 further comprising a blocking capacitor connected between said RF power generator and said D.C. control voltage source.

21. The reactor of Claim 1 wherein said harmonic impedance element comprises a capacitor and an inductor connected in parallel with one another and in series with said impedance match network.

22. The reactor of Claim 21 wherein said impedance match network is a pi-network comprising a pair of parallel capacitors and a series inductor connected therebetween.

23. An RF plasma reactor for processing a workpiece in a plasma region within a chamber of said reactor, said reactor comprising:

an RF power applicator facing said plasma region;
an RF power generator having a fundamental frequency;
an impedance match network connected between said RF power generator and said RF power applicator; and
a harmonic impedance element connected between said impedance match network and said RF power applicator, wherein:
(a) said harmonic impedance element having an impedance at said fundamental frequency such that said impedance match network in combination with said harmonic impedance element provides at least an approximate impedance match at said fundamental frequency with a load impedance of said chamber,
(b) said harmonic impedance element having an impedance at a harmonic frequency of said fundamental frequency which is at least as great as said load impedance at said harmonic frequency, whereby to impede current flow at said harmonic frequency.

24. The reactor of Claim 23 wherein the impedance of said impedance matching element at said harmonic frequency is less than said load impedance at said harmonic frequency.

25. The reactor of Claim 24 wherein said impedance of said impedance matching element is optimized to approximate said conjugate impedance of said load impedance across a limited range of said load impedance.

26. The reactor of Claim 25 wherein RF generator comprises a frequency tuning impedance match servo and said impedance of said matching element is optimized across a tuning frequency range of said frequency tuning impedance match servo.

27. The reactor of Claim 23 wherein said RF power applicator comprises a workpiece support in said chamber whereby said RF power applicator is capacitively coupled, and said plasma sheath overlies said workpiece.

28. The reactor of Claim 26 further comprising an inductive power applicator receiving RF plasma source power, wherein said RF power generator furnishes plasma bias power to said capacitively coupled RF power applicator.

29. The reactor of Claim 23 wherein said impedance of said harmonic impedance element near said harmonic frequency is predominantly reactive, having a phase angle near said harmonic frequency at least near ±90°.

30. The reactor of Claim 29 wherein said impedance of said harmonic impedance element near said harmonic frequency is predominantly inductive, having a phase angle near +90°.

31. The reactor of Claim 23 wherein said impedance of said harmonic impedance element near respective harmonic frequencies of said fundamental frequency are at least as great as said load impedance at said respective harmonic frequencies.

32. The reactor of Claim 31 wherein said impedance of said harmonic impedance element near said respective harmonic frequencies is predominantly reactive, having a phase angle near said harmonic frequency at least near ±90°.

33. The reactor of Claim 32 wherein said impedance of said harmonic impedance element near said respective harmonic frequencies is predominantly inductive, having a phase angle near +90°.

34. The reactor of Claim 28 wherein said fundamental frequency is in a low frequency range wherein ions in said plasma can substantially follow cycling of the RF field in the plasma sheath near said workpiece, and said inductively coupled source power provides a high ion density plasma in said chamber.

35. The reactor of Claim 34 wherein said low frequency range encompasses frequencies on the order of about 2 MHz.

36. The reactor of Claim 23 wherein said impedance match network comprises reactive components having fixed values, and said RF generator comprises a frequency servo loop which maintains an impedance match.

37. The reactor of Claim 23 wherein said impedance match network comprise reactive components of which at least one is variable, and said RF generator comprises a servo loop which varies said variable reactive component to maintain an impedance match.

38. In an RF plasma reactor comprising a reactor chamber for enclosing a plasma, including a process gas inlet, a workpiece support, an RF signal applicator facing a portion of the interior of said chamber and an RF signal generator coupled to a power applicator of said reactor through an impedance match network and having a controllable RF frequency and an RF signal output coupled to an input of said RF signal applicator, a tuning method comprising:

isolating said impedance match network from harmonics of said controllable RF frequency generated in or near said plasma;
measuring, near one of or between (a) the output of said generator and (b) at said signal applicator, a parameter governing plasma ion density in said reactor;
adjusting said frequency of said RF signal generator within a certain frequency range so as to at least nearly optimize said parameter to one of a maximum or minimum value within said frequency range.

39. The method of Claim 38 further comprising providing fixed reactive components in said impedance match network.

40. The method of Claim 38 wherein said parameter comprises a Fourier component of the magnitude of the RF current flow to said RF signal applicator.

41. The method of Claim 40 wherein said Fourier component comprises one of: (a) a first harmonic, (b) a second harmonic.

42. The method of Claim 38 wherein said parameter comprises the magnitude of the time rate of change in RF current flow in said RF signal applicator.

43. The method of Claim 42 wherein said parameter comprises a product of said RF frequency multiplied by said RF current.

44. The method of Claim 38 wherein said RF signal applicator comprises an inductive coil antenna adjacent said reactor chamber and said RF signal generator furnishes RF plasma source signal.

45. The method of Claim 38 wherein said RF signal applicator comprises a capacitive electrode adjacent said reactor chamber and said RF signal generator furnishes RF plasma source signal.

46. The method of Claim 38 wherein said RF signal generator has an RF signal output level which is adjustable, said method further comprising:

varying said RF signal output level so as to set and maintain said parameter at least near a desired set point.

47. The method of Claim 38 wherein said reactor further comprises a bias RF signal generator having a controllable RF bias frequency and a bias signal output coupled to said workpiece support, said method further comprising:

measuring near said workpiece support a bias signal parameter related to a voltage of said workpiece;
adjusting said frequency of said bias RF signal generator within a second frequency range so as to at least nearly optimize said bias signal parameter to one of a maximum or minimum value.

48. The method of Claim 47 further comprising providing a fixed tuning circuit between said bias RF signal generator and said wafer support.

49. The method of Claim 47 wherein said bias signal parameter comprises a Fourier component of the voltage of said workpiece.

50. The method of Claim 49 wherein said Fourier component comprises one of: (a) a first harmonic, (b) a second harmonic, (c) a D.C. component.

51. The method of Claim 47 wherein said bias RF signal generator has a bias RF signal output level which is adjustable, said method further comprising:

varying said bias RF signal output level so as to set and maintain said bias signal parameter at least nearly at a desired set point.

52. The method of Claim 38 further comprising providing a transformer between said RF signal generator and said RF signal applicator.

53. The method of Claim 52 wherein said transformer has a transformer ratio corresponding to an anticipated ratio between magnitudes of said load impedance at said input of said RF signal applicator and said output impedance of said RF signal generator.

54. The method of Claim 38 further comprising:

providing transformer apparatus having plural selectable transformer ratios between said RF signal generator and said RF signal applicator; and

selecting one of said ratios best corresponding to an anticipated ratio between magnitudes of said load impedance at said input of said RF signal applicator and said output impedance of said RF signal generator.

55. The method of Claim 47 further comprising providing a bias transformer between said bias RF signal generator and said wafer support.

56. The method of Claim 55 wherein said bias transformer has a bias transformer ratio corresponding to an anticipated ratio between magnitudes of said bias load impedance at said wafer support and said output impedance of said bias RF signal generator.

57. The method of Claim 47 further comprising:

providing bias transformer apparatus having plural selectable bias transformer ratios between said bias RF signal generator and said wafer support; and

selecting one of said bias ratios best corresponding to an anticipated ratio between magnitudes of said bias load impedance at said wafer support and said output impedance of said bias RF signal generator.

58. In an RF plasma reactor comprising a reactor chamber with a process gas inlet, said reactor chamber for containing a workpiece to be processed, an RF signal applicator facing a portion of the interior of said chamber, and an RF signal generator having a controllable RF frequency and an RF signal output coupled through an impedance match network to an input of said RF signal applicator, a tuning method comprising:

isolating said impedance match network from at least one or more harmonics of said controllable RF frequency as may be produced in said chamber;

sensing a parameter related to a voltage of said workpiece;

adjusting said frequency of said RF signal generator within a frequency range so as to at least nearly optimize said parameter to one of a maximum or minimum value within said frequency range.

59. The method of Claim 58 wherein said RF signal applicator is a capacitive electrode.

60. The method of Claim 58 wherein said reactor further comprises a workpiece support inside said chamber and RF signal generator is coupled to said workpiece support, whereby said RF signal applicator comprises said workpiece support.

61. The method of Claim 58 wherein said impedance match network comprises a fixed tuning circuit between said RF signal generator and said RF signal applicator.

62. The method of Claim 58 wherein said parameter comprises a Fourier component of the RF voltage of said RF signal applicator.

63. The method of Claim 62 wherein said Fourier component comprises one of: (a) a first harmonic, (b) a second harmonic, (c) a D.C. component.

64. The method of Claim 58 wherein said bias RF signal generator has a bias RF signal output level which is adjustable, said method further comprising:

varying said RF signal output level so as to at least nearly set and maintain the magnitude of said parameter at a desired set point.

65. The method of Claim 58 further comprising providing a transformer between said RF signal generator and said RF signal applicator.

66. The method of Claim 65 wherein said transformer has a transformer ratio corresponding to an anticipated ratio between magnitudes of said load impedance at said input of said RF signal applicator and said output impedance of said RF signal generator.

67. The method of Claim 58 further comprising:

providing transformer apparatus having plural selectable transformer ratios between said RF signal generator and said RF signal applicator; and

selecting one of said ratios best corresponding to an anticipated ratio between magnitudes of said load impedance at said input of said RF signal applicator and said output impedance of said RF signal generator.

68. An RF plasma reactor comprising:

a reactor chamber with a process gas inlet and adapted to accept a workpiece to be processed;
an RF signal applicator facing a portion of the interior of said chamber;
an RF signal generator coupled to said RF signal applicator and having an RF frequency control input;
a sensor coupled to said RF signal applicator and responsive to a parameter related to an RF voltaae of said RF signal applicator;
a frequency servo responsive to said sensor and programmed to adjust said frequency of said RF signal generator within a frequency range so as to optimize said parameter to one of a maximum or minimum within said frequency range;
a fixed tuning circuit between said RF signal generator and said RF signal applicator; and
a harmonic impedance element between said tuning circuit and said signal applicator and having an impedance which is higher than that of said tuning circuit near at least one or more harmonics of said frequency.

69. The reactor of Claim 68 wherein said RF signal applicator is a capacitive electrode.

70. The reactor of Claim 69 wherein said reactor further comprises a workpiece support inside said chamber and said RF signal generator is coupled to said workpiece support, whereby said RF signal applicator comprises said workpiece support.

71. The reactor of Claim 68 wherein said parameter comprises a Fourier component of the RF voltage of said RF signal applicator.

72. The reactor of Claim 71 wherein said Fourier component comprises one of: (a) a first harmonic, (b) a second harmonic, (c) a D.C. component.

73. The reactor of Claim 68 wherein said bias RF signal generator has an RF signal level control input, said reactor further comprising:

a signal servo connected to said signal control input and programmed to vary said RF signal output level control input so as to set and maintain said parameter at least near a desired set point.

74. The reactor of Claim 68 further comprising a transformer between said RF signal generator and said RF signal applicator.

75. The reactor of Claim 74 wherein said transformer has a transformer ratio corresponding to an anticipated ratio between magnitudes of said load impedance at said input of said RF signal applicator and said output impedance of said RF signal generator.

76. The reactor of Claim 68 further comprising:

transformer apparatus having plural selectable transformer ratios between said RF signal generator and said RF signal applicator; and
at least one of said ratios best corresponding to an anticipated ratio between magnitudes of said load impedance at said input of said RF signal applicator and said output impedance of said RF signal generator.

77. In an RF plasma reactor comprising a reactor chamber with a process gas inlet, a workpiece support, an RF signal applicator facing a portion of the interior of said chamber and an RF signal generator having a controllable RF frequency and coupled to said RF signal applicator, a method for tuning said RF signal generator to said RF signal applicator, comprising:

providing a fixed impedance match circuit between said applicator and said generator;
providing a harmonic impedance element between said match circuit and said applicator having an impedance near at least one or more harmonics of said frequency which is higher than the impedance of said fixed impedance match circuit at the same harmonic or harmonics;
measuring, near one of or between (a) said signal generator and (b) said signal applicator, a first RF generator parameter;
adjusting said frequency of said RF signal generator within a certain frequency range so as to at least nearly optimize said RF generator parameter to one of a maximum or minimum value within said frequency range.

78. The method of Claim 77 further comprising:

measuring, near one of or between (a) said signal generator and (b) said signal applicator, second and third RF generator parameters;
adjusting said second RF generator parameter so at to at least nearly optimize said third RF generator parameter with respect to a desired value thereof.

**79.** The method of Claim 78 wherein said first, second and third RF generator parameters are the same RF generator parameter.

**80.** The method of Claim 78 wherein at least one of said first, second and third RF generator parameters is different from the other two.

**81.** The method of Claim 78 wherein each of said first, second and third RF generator parameters is different from each of the others.

**82.** The method of Claim 78 wherein said first, second and third RF generator parameters are each selected from among the following RF generator parameters:

delivered voltage, delivered current, delivered power, reflected power, time rate of change of current, a Fourier component of the voltage, a phase angle between the voltage and current, a phase angle between any two RF generator parameters.

**83.** The method of Claim 77 wherein said signal applicator comprises an RF bias signal applicator.

**84.** An RF plasma reactor comprising:

a reactor chamber with a process gas inlet and adapted to accept a workpiece to be processed;
an RF signal applicator facing a portion of the interior of said chamber;
an RF signal generator having an RF frequency control input and producing an RF signal;
a fixed tuning circuit connected between said RF signal generator and said RF signal applicator;
a sensor coupled to at least one of or between (a) said RF signal applicator and (b) said RF signal generator, and responsive to an RF parameter measurable near one of or between (a) said RF signal applicator and (b) said RF signal generator;
an RF signal magnitude servo responsive to said sensor and programmed to adjust a magnitude of said RF signal of said RF signal generator so as to optimize said parameter to a desired value; and
a harmonic impedance element having an impedance which is higher near at least one or more harmonics of the fundamental frequency of said generator than the impedance of said fixed tuning circuit at said harmonic or harmonics.

**85.** The reactor of Claim 85 wherein said desired value of said parameter is one of a maximum or a minimum value.

**86.** The reactor of Claim 85 wherein said RF signal magnitude servo adjusts the magnitude of one of the following generator parameters: delivered voltage, delivered current, delivered power, reflected power, time rate of change of current, product of current and voltage, a Fourier component of the voltage, a phase angle between the voltage and current, a phase angle between any two RF generator parameters.

**87.** The reactor of Claim 85 wherein said parameter comprises one of the following signal parameters: delivered voltage, delivered current, delivered power, reflected power, time rate of change of current, product of current and voltage, a Fourier component of the voltage, a phase angle between the voltage and current, a phase angle between any two RF generator parameters.

**88.** In an RF plasma reactor comprising a reactor chamber with a process gas inlet, said reactor chamber for containing a workpiece to be processed, an RF signal applicator facing a portion of the interior of said chamber, an RF signal generator having an RF frequency control input and producing an RF signal, a method of tuning said RF signal output to said RF signal applicator, comprising:

providing a fixed tuning circuit connected between said RF signal generator and said RF signal applicator;
providing a harmonic impedance element between said fixed tuning circuit and said RF signal applicator, said harmonic impedance element having an impedance which is greater than that of said tuning circuit at one or more harmonics of the fundamental frequency of said generator;
sensing an RF parameter measurable near one of or between (a) said RF signal applicator and (b) said RF signal generator; and
in response to said sensor, adjusting a magnitude of said RF signal of said RF signal generator so as to optimize said parameter to a desired value as sensed by said sensor.

**89.** The method of Claim 89 wherein said desired value of said parameter is one of a maximum or a minimum value.

**90.** The method of Claim 89 wherein said adjusting adjusts the magnitude of one of the following generator parameters: delivered voltage, delivered current, delivered power, reflected power, time rate of change of current, product of current and voltage, a Fourier component of the voltage, a phase angle between the voltage and current, a phase angle between any two RF generator parameters.

91. The method of Claim 89 wherein said parameter comprises one of the following signal parameters: delivered voltage, delivered current, delivered power, reflected power, time rate of change of current, product of current and voltage, a Fourier component of the voltage, a phase angle between the voltage and current, a phase angle between any two RF generator parameters.

92. An RF plasma reactor for processing a workpiece in a plasma region within a chamber of said reactor, said reactor comprising:

an RF power applicator facing said plasma region;
a combined unit including an RF power generator and electrostatic chuck driver, said combined unit producing a fundamental RF frequency and a D.C. chuck control voltage at an output thereof;
an impedance match network connected between said RF power generator and said RF power applicator; and
a harmonic impedance element connected between said impedance match network and said RF power applicator, wherein:
(a) said harmonic impedance element having an impedance at said fundamental frequency such that said impedance match network in combination with said harmonic impedance element provides at least an approximate impedance match at said fundamental frequency with a load impedance of said chamber,
(b) said harmonic impedance element having an impedance at a harmonic frequency of said fundamental frequency higher than the impedance of said impedance match network at said harmonic frequency, whereby to isolate harmonic frequencies generated in a plasma sheath near said electrode from said impedance match network.

93. The reactor of Claim 93 further comprising:

an output capacitor connected between said harmonic impedance element and said RF power applicator.

94. The reactor of Claim 94 wherein said workpiece support comprises an electrostatic chuck, said reactor further comprising a D.C. control voltage source for said electrostatic chuck connected between said RF power generator and said impedance match network, said reactor further comprising a choke inductor connected in parallel with said output capacitor, said choke inductor comprising a path for D.C. current from said D.C. control voltage source to said electrostatic chuck.

95. In an RF plasma reactor comprising a reactor chamber with a process gas inlet, said reactor chamber for containing a workpiece to be processed, an RF signal applicator facing a portion of the interior of said chamber, and an RF signal generator having a controllable RF frequency and an RF signal output coupled through an impedance match network to an input of said RF signal applicator, a tuning method comprising:

isolating said impedance match network from at least one or more harmonics of said controllable RF frequency as may be produced in said chamber;
deducing ion energy at a surface of said workpiece;
adjusting said frequency of said RF signal generator within a frequency range so as to at least nearly optimize said ion energy to a desired value within said frequency range.

96. The method of Claim 96 wherein said desired value is one of a maximum or minimum value within said frequency range.

VOLTAGE

0

TIME

FIG. 1

VOLTAGE

0

TIME

FIG. 2

ION
POPULATION

B

A

0

ION
ENERGY

FIG. 3

ION
POPULATION

C

D

0

ION
ENERGY

FIG. 4

(PRIOR ART)

# FIG. 5A

FIG. 5B

FIG. 5C

FIG. 6

FIG. 7

FIG. 8

FIG. 9

FIG. 10

FIG. 11

FIG. 12

FIG. 13

FIG. 14

FIG. 15

FIG. 16

FIG. 17A

FIG. 17B

FIG. 17C

FIG. 17D

FIG. 17E

FIG. 17F

FIG. 18

FIG. 19

FIG. 20

FIG. 21

SET RF GENERATOR OUTPUT TO INITIAL PARAMETER LEVEL AND FREQUENCY ─650

SAMPLE MAGNITUDE OF THE SELECTED OUTPUT PARAMETER ─660

ADJUST RF GENERATOR OUTPUT FREQUENCY TO OPTIMIZE A PARAMETER ─670

ADJUST RF GENERATOR OUTPUT LEVEL TO OPTIMIZE A PARAMETER

680

DOES FREQUENCY NEED RE-ADJUSTING ? 685

YES

NO

DOES OUTPUT POWER LEVEL NEED RE-ADJUSTING ? 690

YES

NO

FIG. 22

START

SAMPLE AND STORE
PEAK CURRENT — 700

SAMPLE AND STORE FREQUENCY — 705

IS
FREQ.
x
CURRENT PRODUCT
INCREASING OR
DECREASING
? — 710

NO → DELAY

YES

DETERMINE DIRECTION
(INCREASING OR DECREASING)
AND INCREMENT THE FREQUENCY — 720

HAS
TREND
SLOWED
DOWN
? — 730

NO → DECREMENT
FREQUENCY — 750

YES

CONTINUE UNTIL DESIRED FREQUENCY
x CURRENT PRODUCT IS RESTORED — 740

FIG. 23

38

FIG. 24

FIG. 25